# EUROPÄISCHE PATENTANMELDUNG

(11) **EP 3 772 109 A1**
(43) Veröffentlichungstag der Anmeldung: **03.02.2021**
(21) Anmeldenummer: 20188674.4
(22) Anmeldetag: 30.07.2020
(51) Int. Cl.: H01L 29/26, H01L 29/16, B82Y 10/00, H01L 21/768, H01L 23/522, H01L 29/06, H01L 29/66, H01L 29/737, H01L 29/861, B82Y 40/00, H01L 21/331, H01L 21/329

(54) **VERTIKALE VERBINDUNGSHALBLEITER-STRUKTUR UND VERFAHREN ZUM HERSTELLEN DERSELBIGEN**

(30) Priorität: 31.07.2019 DE 102019211468
(71) Anmelder: FRAUNHOFER-GESELLSCHAFT zur Förderung der angewandten Forschung e.V., 80686 München (DE)
(72) Erfinder: RAMM, Peter, 80686 München (DE); KLUMPP, Armin, 80686 München (DE)
(74) Vertreter: König, Andreas Rudolf

(57) **Zusammenfassung**

Die Erfindung betrifft eine vertikale Verbindungshalbleiter-Struktur (100) mit einem Substrat (10) mit einer ersten Hauptoberfläche (11) und einer gegenüberliegenden zweiten Hauptoberfläche (12), einer vertikalen Kanalöffnung (13), die sich zwischen der ersten Hauptoberfläche (11) und der zweiten Hauptoberfläche (12) vollständig durch das Substrat (10) hindurch erstreckt, und einem innerhalb der vertikalen Kanalöffnung (13) angeordneten Schichtstapel (20). Der Schichtstapel (20) weist eine innerhalb der vertikalen Kanalöffnung (13) angeordnete elektrisch leitfähige Schicht (31) und eine innerhalb der vertikalen Kanalöffnung (13) angeordnete Verbindungshalbleiter-Schicht (21) auf. Die Verbindungshalbleiter-Schicht (21) weist einen auf der elektrisch leitfähigen Schicht (31) angeordneten und mit der elektrisch leitfähigen Schicht (31) galvanisch verbundenen Verbindungshalbleiter auf. Die Erfindung betrifft ferner ein Verfahren zum Herstellen einer derartigen vertikalen Verbindungshalbleiter-Struktur (100).

## Beschreibung

Die Erfindung betrifft eine vertikale Verbindungshalbleiter-Struktur mit mindestens einer vertikalen Kanalöffnung und einem darin integrierten Schichtstapel, der mindestens eine Verbindungshalbleiter-Schicht aufweist, sowie ein dreidimensionales Halbleiter-Bauelement mit einer solchen vertikalen Verbindungshalbleiter-Struktur, und ein Verfahren zum Herstellen einer solchen vertikalen Verbindungshalbleiter-Struktur.

Die vorliegende Erfindung kann besonders vorteilhaft im Bereich der SD-Systemintegration eingesetzt werden. Unter dreidimensionaler Integration versteht man die vertikale Verbindung (mechanisch und elektrisch) von Bauelementen, die mittels Planartechnik hergestellt wurden. Letztere werden auch als zweidimensionale bzw. 2D-Systeme bezeichnet, da die Schaltungsstrukturen in einer waagerechten bzw. horizontalen zweidimensionalen Ebene (auch als waagerechte bzw. horizontale Haupt-Substratebene bezeichnet) angeordnet sind. Mindestens zwei übereinander angeordnete, in konventioneller Planartechnik hergestellte, zweidimensionale Systeme können dann wiederum vertikal miteinander verbunden werden, um so ein 3D-System zu bilden. Die vertikale Richtung bezieht sich hierbei auf die oben genannte waagerechte bzw. horizontale zweidimensionale Ebene des jeweiligen 2D-Systems bzw. auf die sich planar (horizontal) über das jeweilige Substrat erstreckenden Bauelementstrukturen, wie z.B. integrierte Schaltkreise oder dotierte Regionen, wobei die vertikale Richtung im Wesentlichen senkrecht zur waagerechten bzw. horizontalen Ebene verläuft. Ein 3D-System (vertikal und horizontal) kann demnach mindestens zwei oder mehrere vertikal übereinander angeordnete 2D-Systeme (horizontal) aufweisen.

Bei den 3D-Systemen wird im Wesentlichen in zwei Hauptgruppen unterschieden. Beim sogenannten 3D-Packaging werden zwei oder mehr eigenständige Baugruppen, wie zum Beispiel Chips oder Dies, vertikal übereinander gestapelt und in einem dreidimensional angeordneten Package integriert. Die einzelnen Baugruppen werden untereinander mittels vertikaler Durchkontaktierungen verbunden. Hierbei werden die Schaltkreise der einzelnen Chips nicht in einem einzigen gemeinsamen Schaltkreis integriert. Sie kommunizieren weiterhin außerhalb des Chips über elektrische Signale, genauso als wenn sie in unterschiedlichen Gehäusen auf eine Leiterplatte montiert wären. Bei den sogenannten 3D-ICs (IC - engl.: Integrated Circuit) hingegen werden mehrere Komponenten eines gemeinsamen Schaltkreises vertikal übereinander angeordnet und mittels vertikaler Durchkontaktierungen zu einem einzigen gemeinsamen Schaltkreis verbunden. Das heißt, ein 3D-IC wirkt wie ein einzelner IC. Alle Komponenten auf allen Chip-Ebenen kommunizieren innerhalb des 3D-ICs miteinander, je nachdem wie er entworfen wurde, sowohl vertikal als auch horizontal.

Wenn im Sinne der vorliegenden Offenbarung von einer dreidimensionalen Systemintegration, einem 3D-System, einem dreidimensionalen Halbleiterbauelement und dergleichen die Rede ist, dann sind damit stets beide oben genannten Hauptgruppen gemeint.

Die Vorteile eines dreidimensional integrierten mikroelektronischen Systems sind u.a. die bei gleichen Designregeln erreichbaren höheren Packungsdichten und Schaltgeschwindigkeiten gegenüber, konventionell in Planartechnik gefertigten, zweidimensionalen Systemen. Diese höheren Schaltgeschwindigkeiten sind zum einen bedingt durch kürzere Leitungswege zwischen den einzelnen Bauelementen oder Schaltungen, zum anderen durch die Möglichkeit der parallelen Informationsverarbeitung.

Die Steigerung der Leistungsfähigkeit des Systems ist bei Realisierung einer Verbindungstechnik mit örtlich frei wählbaren höchstintegrierbaren vertikalen Kontakten durch das Substrat (im Falle von Silizium: TSV - Through Silicon Via) optimal.

Stand der Technik bei der 3D-Integration mit frei wählbaren Through-Silicon Vias - der sogenannten 3D-IC Technologie (Handbook of 3D Integration, Vol. 1) - ist u. a. mit dem Patent EP 1 171 912 B1 (Verfahren zur vertikalen Integration von elektronischen Bauelementen mittels Rückseitenkontaktierung) beschrieben.

Bei der 3D-IC Integration werden Through-Silicon Vias im Laufe der Prozessierung in den entsprechenden Bauelementen hergestellt. Ein erfolgversprechender Lösungsansatz ist es, die TSVs nach Abschluss der sogenannten Front-End-of-Line Prozesse jedoch vor den sogenannten Back-End-of-Line (BEOL) Prozessen herzustellen. Dieses wie auch andere ähnliche Konzepte erfordern nachteilhaft die Kompatibilität der TSV-Prozesse mit den Halbleiterfertigungsprozessen.

Die vertikale Integration wird gemäß dem Stand der Technik zwischen planaren Bauelementstrukturen in verschiedenen Substraten bzw. Substratebenen realisiert. Dies führt zu einer hohen Integrationsdichte auf, in lateraler Richtung gesehenen, kleinstem Raum. Die laterale Ausdehnung der Bauelementstrukturen und deren Verdrahtung limitiert jedoch, neben den lateralen Abmessungen der Substratdurchkontaktierungen, prinzipiell die erreichbare Integrationsdichte der dreidimensional integrierten Bauelemente.

Es ist daher eine Aufgabe der Erfindung, die Integrationsdichte gegenüber herkömmlichen 3D-Systemen deutlich zu erhöhen, bei im Wesentlichen gleichbleibenden lateralen als auch vertikalen Abmessungen.

Zur Lösung dieser Aufgabe werden eine vertikale Verbindungshalbleiter-Struktur mit den Merkmalen von Anspruch 1 sowie ein Verfahren zum Herstellen derselbigen mit den Merkmalen von Anspruch 14 vorgeschlagen. Ausführungsformen und weitere vorteilhafte Aspekte sind in den jeweils abhängigen Patentansprüchen genannt.

Die erfindungsgemäße vertikale Verbindungshalbleiter-Struktur weist ein Substrat mit einer ersten Hauptoberfläche und einer gegenüberliegenden zweiten Hauptoberfläche auf. Das Substrat kann beispielsweise Silizium, Glas oder Quarz aufweisen. In dem Substrat ist eine vertikale Kanalöffnung vorgesehen, die sich zwischen der ersten Hauptoberfläche und der zweiten Hauptoberfläche vollständig durch das Substrat hindurch erstreckt. Innerhalb dieser vertikalen Kanalöffnung ist ein vertikaler Schichtstapel angeordnet. Der Schichtstapel erstreckt sich vertikal innerhalb der vertikalen Kanalöffnung. Der Schichtstapel weist eine innerhalb der vertikalen Kanalöffnung, und entlang der Erstreckungsrichtung der vertikalen Kanalöffnung, angeordnete elektrisch leitfähige Schicht und eine innerhalb der vertikalen Kanalöffnung, und entlang der Erstreckungsrichtung der vertikalen Kanalöffnung, angeordnete Verbindungshalbleiter-Schicht auf. Die Verbindungshalbleiter-Schicht weist einen auf der elektrisch leitfähigen Schicht angeordneten und mit der elektrisch leitfähigen Schicht galvanisch verbundenen Verbindungshalbleiter auf. Dadurch kann die Integrationsdichte vorteilhaft und deutlich gegenüber herkömmlichen Systemen erhöht werden. Bei konventionellen 3D-Systemen werden mindestens zwei zweidimensionale Systeme mit darauf angeordneten planaren Bauelement-Strukturen übereinander gestapelt und mittels vertikaler Durchkontaktierungen miteinander verbunden. Die vertikalen Durchkontaktierungen dienen dabei ausschließlich der gegenseitigen galvanischen und gegebenenfalls mechanischen Verbindung der planaren Bauelement-Strukturen der zweidimensionalen Systeme. Bei der erfindungsgemäßen Vorrichtung hingegen wird der in den vertikalen Durchkontaktierungen zur Verfügung stehende Raum zusätzlich und höchst effektiv ausgenutzt, um darin, alternativ oder zusätzlich zu den konventionellen planaren Bauelement-Strukturen, ein oder mehrere erfindungsgemäße vertikale Bauelement-Strukturen zu integrieren. Besonders vorteilhaft können hierbei Halbleiterbauelement-Strukturen mit mindestens einem Verbindungshalbleiter in den vertikalen Durchkontaktierungen (Kanalöffnungen) integriert werden. Dabei wird in der Kanalöffnung, in denen eine vertikale Durchkontierung erzeugt werden kann, der eingangs erwähnte vertikale Schichtstapel erzeugt. Der Schichtstapel weist eine elektrisch leitfähige Schicht auf, die von außen kontaktierbar ist. Hierbei kann es sich vorzugsweise um eine Metallisierungsschicht handeln. Der Schichtstapel weist ferner eine Verbindungshalbleiter-Schicht auf, die einen vorzugsweise direkt und unmittelbar auf der elektrisch leitfähigen Schicht angeordneten und mit der elektrisch leitfähigen Schicht galvanisch verbundenen Verbindungshalbleiter aufweist. Im Stand der Technik werden derartige Halbleiterbauelement-Strukturen primär in Siliziumtechnik gefertigt, das heißt es kommen keine Verbindungshalbleiter sondern elementare Halbleiter zum Einsatz. Im Falle von Silizium kann derzeit jedoch höchstens polykristallines Silizium auf der Metallisierungsschicht abgeschieden werden, denn zum Erzeugen von einkristallinem Silizium müsste in der Prozessführung über die Schmelztemperatur von Silizium erhitzt werden, was jedoch zur Zerstörung der darunterliegenden Schichten, wie zum Beispiel der Metallisierungsschicht, führen würde. Bei der erfindungsgemäßen Erzeugung des Schichtstapels mit einem Verbindungshalbleiter bleibt hingegen die elektrisch leitfähige Schicht, z.B. Metallisierungsschicht, intakt. Die elektrisch leitfähige Schicht kann von außen kontaktiert werden, und die elektrisch leitfähige Schicht kann somit über ihre gesamte Fläche die Ladungsträger an die Verbindungshalbleiter-Schicht abgeben, sodass diese vollflächig kontaktiert wird. Mit diesem erfindungsgemäßen Schichtstapel kann eine vertikale Verbindungshalbleiter-Struktur erzeugt werden, die innerhalb der vertikalen Kanalöffnung einer Durchkontaktierung angeordnet bzw. darin integriert ist, und dabei dennoch vollflächig kontaktierbar ist. Durch diesen Umstand kann die Integrationsdichte von 3D-Systemen signifikant erhöht werden, da diese nun nicht mehr ausschließlich in planaren Ebenen angeordnete Bauelement-Strukturen sondern auch vertikal integrierte Bauelement-Strukturen aufweisen können.

Gemäß einem Ausführungsbeispiel kann die Verbindungshalbleiter-Schicht einen monokristallinen Verbindungs-Halbleiter aufweisen. Monokristalline bzw. einkristalline Verbindungs-Halbleiter weisen im Vergleich zu polykristallinen Strukturen besonders gute elektrische Eigenschaften auf. Daher wäre in den bisherigen Silizium-basierten Verfahren der Einsatz von monokristallinem Silizium bevorzugt. Wie eingangs erwähnt, kann heutzutage allerdings aufgrund der verfügbaren Prozesse höchstens polykristallines Silizium direkt auf einer elektrisch leitfähigen Schicht, und insbesondere auf einer Metallisierungsschicht, abgeschieden werden. Die hierin beschriebene Erfindung ermöglicht es, einkristallines Verbindungshalbleiter-Material direkt auf der elektrisch leitfähigen Schicht anzuordnen. Zu einkristallinem Verbindungshalbleiter-Material zählen auch Einkristalle aus mehr oder weniger komplexen chemischen Verbindungen.

Gemäß einem weiteren Ausführungsbeispiel kann die Verbindungshalbleiter-Schicht mindestens ein 2D-Verbundmaterial aufweisen. Ein 2D-Verbundmaterial ist nicht zu verwechseln mit den ebenfalls hierin beschriebenen 2D-Systemen. 2D-Materialien, die gelegentlich auch als Single Layer oder Monolayer Materialien bezeichnet werden, sind kristalline Materialien, die lediglich eine einzelne Atomlage aufweisen. Mehrere dieser Monolayer können übereinander gestapelt werden. 2D-Materialien haben die Eigenschaft, dass diese einkristallin abgeschieden bzw. umgesetzt werden. Aufgrund ungewöhnlicher Eigenschaften sind sie Gegenstand umfangreicher (Grundlagen-)Forschungen. Allgemein können 2D-Materialien entweder als zweidimensionale Allotrope unterschiedlicher Elemente oder als Verbindung verschiedener Elemente mit kovalenter Bindung, sogenannte 2D-Verbundmaterialien, angesehen werden. Ein bekannter Vertreter eines allotropen 2D-Materials ist beispielsweise Graphen. Als nicht-limitierende und nicht abschließende Beispiele für 2D-Verbundmaterialien können u.a. Graphan, Boronitren, Germaniumphosphid und Molybdän(IV)-sulfid genannt werden. Im Folgenden sollen insbesondere die Verbindungen verschiedener Elemente, d.h. 2D-Verbundmaterialien, und hierbei insbesondere Verbindungshalbleiter, betrachtet werden. Die effiziente Integration von 2D-Materialien in 3D-Systemen stellt nach wie vor eine außerordentliche Herausforderung sowie einen limitierenden Faktor bei der Gesamtleistung des Systems und beim Schaltungsdesign dar.

Gemäß einem weiteren Ausführungsbeispiel kann die Verbindungshalbleiter-Schicht mindestens ein Material aus der Gruppe der Übergangsmetall-Chalkogenide aufweisen. Übergangsmetall-Chalkogenide werden auch als TMDs (engl.: Transition Metal Dichalcogenides) bezeichnet. TMDs sind in der Regel aus drei atomaren Ebenen aufgebaut und beinhalten meist zwei verschiedene atomare Spezies, nämlich ein Metall und zwei Chalkogenide. Die auch als TMD-Monolayer bezeichneten Übergangsmetall-Chalkogenide sind atomar dünne Halbleiter vom Typ MX₂, wobei M ein Übergangsmetall-Atom (z.B. Mo, W, etc.) bezeichnet und X ein Chalkogenid-Atom (z.B. S, Se oder Te) bezeichnet. Dabei ist in der Regel eine Lage von M-Atomen zwischen zwei Lagen von X-Atomen angeordnet. Diese Anordnungen zählen zu der übergeordneten Gruppe von 2D-Matierialien. TMD Monolayer, wie zum Beispiel MoS₂, WS₂, MoSe₂, WSe₂, MoTe₂ haben eine direkte Bandlücke, was sie für die Verwendung als Verbindungshalbleiter in der erfindungsgemäßen Verbindungshalbleiter-Schicht auszeichnet.

Gemäß einem weiteren Ausführungsbeispiel kann die Verbindungshalbleiter-Schicht Molybdändisulfid MoS₂ aufweisen. Molybdändisulfid eignet sich aufgrund seiner elektrischen Eigenschaften besonders gut als Verbindungshalbleiter in der erfindungsgemäßen Verbindungshalbleiter-Schicht. Zudem weist ein MoS₂ Monolayer eine Dicke von gerade einmal 6.5 Å auf, weshalb er sich besonders dazu eignet, um in die vertikale Kanalöffnung integriert zu werden.

Gemäß einem weiteren Ausführungsbeispiel kann die Verbindungshalbleiter-Schicht mittels Abscheidung auf der elektrisch leitfähigen Schicht angeordnet sein. Dabei kann die Verbindungshalbleiter-Schicht direkt auf der elektrisch leitfähigen Schicht, z.B. Metallisierungsschicht, abgeschieden werden. Das Abscheiden des Verbindungshalbleitermaterials stellt eine einfache und verhältnismäßig kostengünstige Möglichkeit dar, um die Verbindungshalbleiter-Schicht auf der elektrisch leitfähigen Schicht anzuordnen.

Gemäß einem alternativen Ausführungsbeispiel kann die Verbindungshalbleiter-Schicht mittels chemischer Umsetzung aus zumindest einem Teil der elektrisch leitfähigen Schicht gebildet sein. Alternativ oder zusätzlich kann die Verbindungshalbleiter-Schicht mittels chemischer Umsetzung aus zumindest einem Teil einer auf der elektrisch leitfähigen Schicht abgeschiedenen weiteren Schicht (z.B. eine Metallisierungsschicht) gebildet sein. Unter der chemischen Umsetzung versteht man ein neuartiges Verfahren, das sich von den eingangs erwähnten Abscheideverfahren unterscheidet. Bei der chemischen Umsetzung werden sozusagen Teile einer Ausgangsschicht durch chemische Reaktionen in die Verbindungshalbleiter-Schicht umgewandelt. Als Ausgangsschicht kann die elektrisch leitfähige Schicht, oder eine weitere Schicht, dienen. Bevorzugt handelt es sich bei der Ausgangsschicht um eine Metallisierungsschicht, und insbesondere um ein Übergangsmetall, wie zum Beispiel Molybdän. Dieses kann beispielsweise mittels geeigneter Reaktionspartner, wie zum Beispiel Schwefel, umgesetzt werden. Bei dieser chemischen Umsetzung entsteht eine Verbindungshalbleiter-Schicht aus einem 2D-Material, die einen TMD Monolayer aufweist, in diesem Falle MoS₂.

Gemäß einem weiteren Ausführungsbeispiel kann der Schichtstapel eine innerhalb der vertikalen Kanalöffnung, und entlang der Erstreckungsrichtung der vertikalen Kanalöffnung, angeordnete zweite Verbindungshalbleiter-Schicht aufweisen, die auf der Verbindungshalbleiter-Schicht angeordnet und galvanisch mit dieser verbunden ist. Dabei ist die zweite Verbindungshalbleiter-Schicht auf der der elektrisch leitfähigen Schicht gegenüberliegenden Seite der Verbindungshalbleiter-Schicht angeordnet, sodass die Verbindungshalbleiter-Schicht zwischen der elektrisch leitfähigen Schicht und der zweiten Verbindungshalbleiter-Schicht angeordnet ist. Mittels dieser Anordnung kann beispielsweise eine Diodenstruktur innerhalb der vertikalen Kanalöffnung erzeugt werden.

Gemäß einem weiteren Ausführungsbeispiel kann die zweite Verbindungshalbleiter-Schicht mindestens ein 2D-Verbundmaterial aufweisen. Die zweite Verbindungshalbleiter-Schicht kann demnach beispielsweise, ebenso wie die oben erwähnte (erste) Verbindungshalbleiter-Schicht, mindestens ein Material aus der Gruppe der Übergangsmetall-Chalkogenide, und insbesondere MoS₂ aufweisen.

Gemäß einem weiteren Ausführungsbeispiel kann der Schichtstapel eine innerhalb der vertikalen Kanalöffnung, (und entlang der Erstreckungsrichtung der vertikalen Kanalöffnung, angeordnete dritte Verbindungshalbleiter-Schicht aufweisen, die auf der zweiten Verbindungshalbleiter-Schicht angeordnet und galvanisch mit dieser verbunden ist. Dabei ist die dritte Verbindungshalbleiter-Schicht auf der der Verbindungshalbleiter-Schicht gegenüberliegenden Seite der zweiten Verbindungshalbleiter-Schicht angeordnet, sodass die zweite Verbindungshalbleiter-Schicht zwischen der Verbindungshalbleiter-Schicht und der dritten Verbindungshalbleiter-Schicht angeordnet ist. Mittels dieser Anordnung kann beispielsweise eine Transistorstruktur innerhalb der vertikalen Kanalöffnung erzeugt werden.

Gemäß einem weiteren Ausführungsbeispiel kann die dritte Verbindungshalbleiter-Schicht mindestens ein 2D-Verbundmaterial aufweisen. Die dritte Verbindungshalbleiter-Schicht kann demnach beispielsweise, ebenso wie die oben erwähnte (erste) Verbindungshalbleiter-Schicht und/oder die zweite Verbindungshalbleiter-Schicht, mindestens ein Material aus der Gruppe der Übergangsmetall-Chalkogenide, und insbesondere MoS₂ aufweisen.

Gemäß einem weiteren Ausführungsbeispiel kann der Schichtstapel eine innerhalb der vertikalen Kanalöffnung, und entlang der Erstreckungsrichtung der vertikalen Kanalöffnung, angeordnete zweite elektrisch leitfähige Schicht aufweisen, die auf der dritten Verbindungshalbleiter-Schicht angeordnet und galvanisch mit dieser verbunden ist. Dabei ist die zweite elektrisch leitfähige Schicht auf der der zweiten Verbindungshalbleiter-Schicht gegenüberliegenden Seite der dritten Verbindungshalbleiter-Schicht angeordnet, sodass die dritte Verbindungshalbleiter-Schicht zwischen der zweiten Verbindungshalbleiter-Schicht und der zweiten elektrisch leitfähigen Schicht angeordnet ist. Diese zweite elektrisch leitfähige Schicht kann von außen kontaktiert werden, und die zweite elektrisch leitfähige Schicht kann somit über ihre gesamte Fläche die Ladungsträger an die dritte Verbindungshalbleiter-Schicht abgeben, sodass diese vollflächig kontaktiert wird.

Mit der vertikalen Verbindungshalbleiter-Struktur kann ein dreidimensionales elektronisches Halbleiter-Bauelement (3D-System) hergestellt werden, indem der ersten und/oder der zweiten Hauptoberfläche des Substrats gegenüberliegend eine zusätzliche separate elektronische Bauelementstruktur angeordnet ist, die mittels einem Kontaktierungsabschnitt mechanisch und/oder galvanisch mit der vertikalen Verbindungshalbleiter-Struktur, und insbesondere mit der Verbindungshalbleiter-Schicht, verbunden ist. Bei der zusätzlichen separaten elektronischen Bauelementstruktur kann es sich beispielsweise um ein in Planartechnik gefertigtes zweidimensionales System oder um eine weitere erfindungsgemäße vertikale Verbindungshalbleiter-Struktur handeln. Das so herstellbare 3D-System kann ein 3D-Package oder ein 3D-IC sein.

Die Erfindung betrifft ferner ein Verfahren zum Herstellen einer entsprechenden vertikalen Verbindungshalbleiter-Struktur. Das Verfahren beinhaltet ein Bereitstellen eines Substrats mit einer ersten Hauptoberfläche und einer gegenüberliegenden zweiten Hauptoberfläche, sowie ein Strukturieren einer vertikalen Kanalöffnung, die sich zwischen der ersten Hauptoberfläche und der zweiten Hauptoberfläche vollständig durch das Substrat hindurch erstreckt. Erfindungsgemäß wird ein Schichtstapel innerhalb der vertikalen Kanalöffnung erzeugt. Der Schritt des Erzeugens des Schichtstapels beinhaltet ein Anordnen einer elektrisch leitfähigen Schicht innerhalb der vertikalen Kanalöffnung, und entlang der Erstreckungsrichtung der vertikalen Kanalöffnung, sowie ein Anordnen einer mindestens einen Verbindungshalbleiter aufweisenden Verbindungshalbleiter-Schicht innerhalb der vertikalen Kanalöffnung, und entlang der Erstreckungsrichtung der vertikalen Kanalöffnung. Dabei wird die Verbindungshalbleiter-Schicht auf der elektrisch leitfähigen Schicht angeordnet und mit der elektrisch leitfähigen Schicht galvanisch verbunden. Bezüglich der Vorteile des Verfahrens wird auf die obigen Ausführungen zur entsprechenden Vorrichtung verwiesen.

Einige Ausführungsbeispiele sind nachfolgend exemplarisch in der Zeichnung dargestellt und werden nachstehend erläutert. Es zeigen:
- Fig. 1: eine schematische seitliche Schnittansicht einer vertikalen Verbindungshalbleiter-Struktur gemäß einem Ausführungsbeispiel,
- Fig. 2: ein schematisches Blockdiagramm zur Darstellung einzelner Verfahrensschritte eines Verfahrens zum Herstellen einer vertikalen Verbindungshalbleiter-Struktur gemäß einem Ausführungsbeispiel,
- Fig. 3A: eine schematische seitliche Schnittansicht einer vertikalen Verbindungshalbleiter-Struktur gemäß einem Ausführungsbeispiel,
- Fig. 3B: eine Draufsicht auf die vertikale Verbindungshalbleiter-Struktur aus Figur 3A,
- Fig. 4: eine schematische seitliche Schnittansicht einer vertikalen Verbindungshalbleiter-Struktur mit Anschlussaufbau (Verdrahtung und Ansteuerung) zu einer separaten elektronischen Bauelemente-Struktur zum Herstellen eines dreidimensionalen elektronischen Halbleiterbauelements gemäß einem Ausführungsbeispiel, und
- Fig. 5: eine schematische seitliche Schnittansicht einer vertikalen Verbindungshalbleiter-Struktur mit Anschlussaufbau (Verdrahtung und Ansteuerung) zu einer separaten elektronischen Bauelemente-Struktur zum Herstellen eines dreidimensionalen elektronischen Halbleiterbauelements gemäß einem weiteren Ausführungsbeispiel.

Im Folgenden werden Ausführungsbeispiele mit Bezug auf die Figuren näher beschrieben, wobei Elemente mit derselben oder ähnlichen Funktion mit denselben Bezugszeichen versehen sind.

Verfahrensschritte, die in einem Blockdiagramm dargestellt und mit Bezugnahme auf das selbige erläutert werden, können auch in einer anderen als der abgebildeten beziehungsweise beschriebenen Reihenfolge ausgeführt werden. Außerdem sind Verfahrensschritte, die ein bestimmtes Merkmal einer Vorrichtung betreffen mit ebendiesem Merkmal der Vorrichtung austauschbar, was ebenso anders herum gilt.

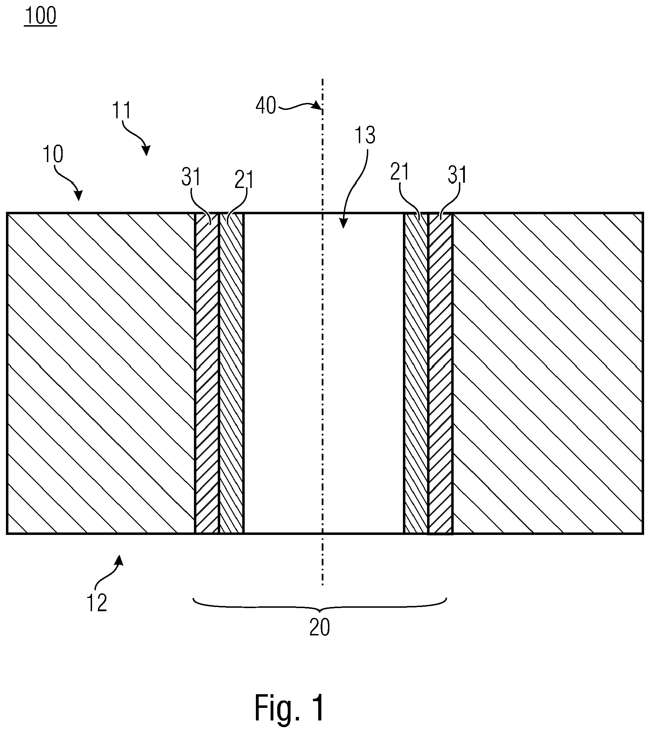

Figur 1 zeigt eine schematische seitliche Schnittansicht einer erfindungsgemäßen vertikalen Verbindungshalbleiter-Struktur 100. Diese weist ein Substrat 10 mit einer ersten Hauptoberfläche 11 und einer gegenüberliegenden zweiten Hauptoberfläche 12 auf.

Zwischen der ersten Hauptoberfläche 11 und der zweiten Hauptoberfläche 12 erstreckt sich eine vertikale Kanalöffnung 13 vollständig durch das Substrat 10 hindurch. Innerhalb der vertikalen Kanalöffnung 13 ist ein Schichtstapel 20 angeordnet.

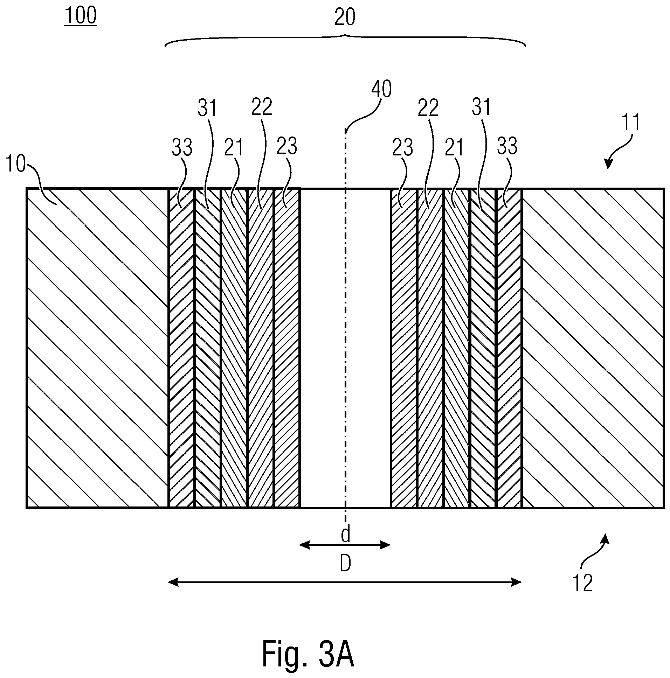

Der Schichtstapel 20 weist eine elektrisch leitfähige Schicht 31 auf. Die elektrisch leitfähige Schicht 31 kann beispielsweise eine Metallisierungsschicht, und insbesondere eine ein Übergangsmetall aufweisende Schicht sein. Die elektrisch leitfähige Schicht 31 ist innerhalb der vertikalen Kanalöffnung 13 angeordnet. Beispielsweise kann die elektrisch leitfähige Schicht 31 an einer lateral umlaufenden Wandung der vertikalen Kanalöffnung 13 angeordnet, z.B. abgeschieden, sein. Die elektrisch leitfähige Schicht 31 kann direkt und unmittelbar auf der Wandung der vertikalen Öffnung 13 angeordnet sein, zum Beispiel wenn das Substrat 10 nicht elektrisch leitend ist. Optional kann eine Isolatorschicht 33 (Figur 3A), z.B. ein Dielektrikum, zwischen der elektrisch leitfähigen Schicht 31 und der Wandung der vertikalen Kanalöffnung 13 vorgesehen sein, zum Beispiel wenn das Substrat 10 elektrisch leitende Eigenschaften aufweist. Die elektrisch leitfähige Schicht 31 kann sich entlang der Erstreckungsrichtung der vertikalen Kanalöffnung 13 erstrecken. Die elektrisch leitfähige Schicht 31 kann außerdem teilweise oder, wie abgebildet, vollständig innerhalb der vertikalen Kanalöffnung 13 angeordnet sein.

Der Schichtstapel 20 weist außerdem eine Verbindungshalbleiter-Schicht 21 auf. Die Verbindungshalbleiter-Schicht 21 ist innerhalb der vertikalen Kanalöffnung 13 angeordnet. Die Verbindungshalbleiter-Schicht 21 kann sich entlang der Erstreckungsrichtung der vertikalen Kanalöffnung 13 erstrecken. Die Verbindungshalbleiter-Schicht 21 kann teilweise oder, wie abgebildet, vollständig innerhalb der vertikalen Kanalöffnung 13 angeordnet sein. Die Verbindungshalbleiter-Schicht 21 kann direkt und unmittelbar auf der elektrisch leitfähigen Schicht 31 angeordnet sein. Die Verbindungshalbleiter-Schicht 21 kann in radialer Richtung näher an einem Zentrum 40 der vertikalen Kanalöffnung 13 angeordnet sein als die elektrisch leitfähige Schicht 31. Das heißt, die Verbindungshalbleiter-Schicht 21 kann innerhalb der vertikalen Kanalöffnung 13 weiter innen angeordnet sein als die elektrisch leitfähige Schicht 31. Es wäre aber ebenso denkbar, dass diese Anordnung umgekehrt ist, das heißt, die elektrisch leitfähige Schicht 31 wäre weiter innen angeordnet als die Verbindungshalbleiter-Schicht 21.

Die Verbindungshalbleiter-Schicht 21 und die elektrisch leitfähige Schicht 31 können dieselbe Schichtdicke aufweisen. Es sind jedoch auch unterschiedliche Schichtdicken denkbar. Beispielsweise kann die Verbindungshalbleiter-Schicht 21 eine geringere Schichtdicke aufweisen als die elektrisch leitfähige Schicht 31. Dies kann unter anderem darin begründet sein, dass die elektrisch leitfähige Schicht 31 dazu dient, um die Verbindungshalbleiter-Schicht 21 möglichst großflächig, und vorzugsweise vollflächig, zu kontaktieren. Die Verbindungshalbleiter-Schicht 21 hingegen kann vorzugsweise als monokristallines 2D-Material ausgestaltet sein, welches lediglich eine oder mehrere wenige (z.B. zwei bis fünf) einzelne Atomlagen aufweist und somit extrem dünn ist.

Erfindungsgemäß weist die Verbindungshalbleiter-Schicht 21 einen auf der elektrisch leitfähigen Schicht 31 angeordneten und mit der elektrisch leitfähigen Schicht 31 galvanisch verbundenen Verbindungshalbleiter auf. Der Verbindungshalbleiter ist definitionsgemäß zu unterscheiden von einem Elementhalbleiter. Während der Elementhalbleiter aus einem einzigen Element, z.B. Silizium aufgebaut ist, sind Verbindungshalbleiter aus mehreren Elementen aufgebaut.

Darüber hinaus ist es vorteilhaft, wenn der Verbindungshalbleiter monokristallin vorliegt. Allerdings kann beispielsweise der Elementhalbleiter Silizium nicht monokristallin auf der elektrisch leitfähigen Schicht abgeschieden werden, da hierfür die Abscheidetemperatur bei der Prozessierung über die Schmelztemperatur von Silizium erhöht werden müsste, was in der Praxis zwangsläufig zu Schäden an den umliegenden Bauteilen und Komponenten führen würde.

Daher kann die Verbindungshalbleiter-Schicht 21 gemäß einer Ausführungsform ein sogenanntes 2D-Material aufweisen. Für eine genauere Definition des 2D-Materials wird auf die Absätze im obigen allgemeinen Beschreibungsteil verwiesen. Das 2D-Material hat die Eigenschaft und somit den Vorteil, dass es einkristallin auf der elektrisch leitfähigen Schicht 31 angeordnet werden kann. Dabei bildet das 2D-Material Schichten aus, die auf Molekularebene aus einzelnen Atomlagen, den sogenannten Monolayern, bestehen. Das 2D-Material kann eine einzelne Atomlage aufweisen, oder mehrere Atomlagen können sich zu einem gemeinsamen 2D-Verbundmaterial zusammenschließen.

Vorteilhafter Weise kann die Verbindungshalbleiter-Schicht 21 mindestens ein Material aus der Gruppe der Übergangsmetall-Chalkogenide aufweisen. Beispielsweise kann die Verbindungshalbleiter-Schicht 21 ein 2D-Verbundmaterial mit mindestens einem Material aus der Gruppe der Übergangsmetall-Chalkogenide aufweisen. Übergangsmetall-Chalkogenide sind atomar dünne Halbleiter vom Typ MX₂, wobei M ein Übergangsmetall-Atom (z.B. Mo, W, etc.) bezeichnet und X ein Chalkogenid-Atom (z.B. S, Se oder Te) bezeichnet. Dabei ist in der Regel eine Lage von M-Atomen zwischen zwei Lagen von X-Atomen angeordnet. Hierzu zählen zum Beispiel MoS₂, WS₂, MoSe₂, WSe₂, MoTe₂, die sich gut zur Verwendung in der Verbindungshalbleiter-Schicht 21 eignen.

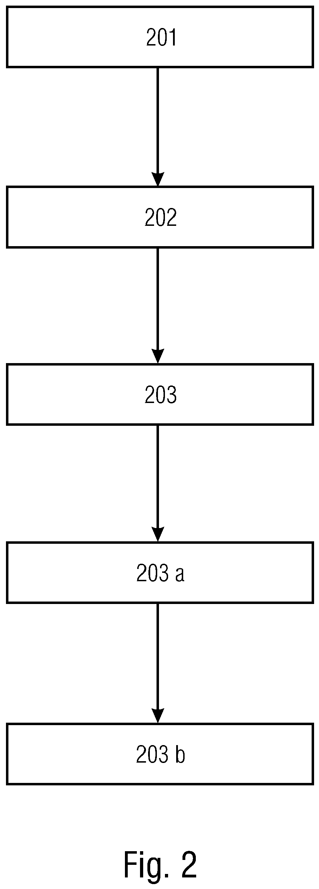

Figur 2 zeigt ein Blockdiagramm für ein erfindungsgemäßes Verfahren zum Herstellen einer hierin beschriebenen vertikalen Verbindungshalbleiter-Struktur 100.

In Block 201 wird ein Substrat 10 mit einer ersten Hauptoberfläche 11 und einer gegenüberliegenden zweiten Hauptoberfläche 12 bereitgestellt.

In Block 202 wird eine vertikale Kanalöffnung 13 in das Substrat 10 strukturiert, die sich zwischen der ersten Hauptoberfläche 11 und der zweiten Hauptoberfläche 12 vollständig durch das Substrat 10 hindurch erstreckt.

In Block 203 wird innerhalb der vertikalen Kanalöffnung 13 ein Schichtstapel 20 erzeugt.

In Block 203a wird, zum Erzeugen des Schichtstapels 20, in einem ersten Schritt eine elektrisch leitfähige Schicht 31 innerhalb der vertikalen Kanalöffnung 13 angeordnet.

In Block 203b wird, zum Erzeugen des Schichtstapels 20, in einem zweiten Schritt eine mindestens einen Verbindungshalbleiter aufweisende Verbindungshalbleiter-Schicht 21 innerhalb der vertikalen Kanalöffnung 13 angeordnet, wobei die Verbindungshalbleiter-Schicht 21 auf der elektrisch leitfähigen Schicht 31 angeordnet und mit der elektrisch leitfähigen Schicht 31 galvanisch verbunden wird. Die Verbindungshalbleiter-Schicht 21 kann direkt bzw. unmittelbar auf der elektrisch leitfähigen Schicht 31 angeordnet werden.

Wenn die Schritte 203a und 203b in der angegebenen Reihenfolge ausgeführt werden, führt dies zu einem Schichtstapel 20, bei dem die elektrisch leitfähige Schicht 31 zwischen der Verbindungshalbleiter-Schicht 21 und dem Substrat 10 angeordnet ist. Optional kann zusätzlich eine Isolatorschicht 33 (Figur 3A) zwischen dem Substrat 10 und der elektrisch leitfähigen Schicht 31 angeordnet werden.

Die Schritte 203a und 203b können jedoch auch umgekehrt ausgeführt werden. In diesem Fall würde sich ein Schichtstapel 20 ergeben, bei dem die Verbindungshalbleiter-Schicht 21 zwischen der elektrisch leitfähigen Schicht 31 und dem Substrat 10 angeordnet ist. Optional kann zusätzlich eine Isolatorschicht 33 (Figur 3A) zwischen dem Substrat 10 und der Verbindungshalbleiter-Schicht 21 angeordnet werden.

Generell gilt, dass alle hierin beschriebenen Verfahrensschritte auch in einer anderen als der angegebenen Reihenfolge ausgeführt werden können.

Die Verbindungshalbleiter-Schicht 21 kann erfindungsgemäß auf zwei unterschiedliche Arten auf der elektrisch leitfähigen Schicht 31 angeordnet werden. In einer ersten Ausführungsform kann die Verbindungshalbleiter-Schicht 21 auf der elektrisch leitfähigen Schicht 31 abgeschieden werden. Die Temperaturen zum Abscheiden von, zum Beispiel einkristallinen 2D-Materialien, können wesentlich geringer sein als die Temperaturen zum Abscheiden von einkristallinem Silizium. Eine Prozesskompatibilität kann dadurch gewährleistet werden.

In einem zweiten Ausführungsbeispiel kann die Verbindungshalbleiter-Schicht 21 mittels chemischer Umsetzung gebildet werden. Hierfür kann ein Teil der elektrisch leitfähigen Schicht 31 mittels geeigneter Reaktionspartner in eine Verbindungshalbleiter-Schicht 21 umgewandelt bzw. umgesetzt werden. Beispielsweise kann die elektrisch leitfähige Schicht 31 ein Material aus der Gruppe der Übergangsmetalle aufweisen, wie z.B. Molybdän. Ein geeigneter Reaktionspartner zur Umsetzung wäre beispielsweise Schwefel. Der Schwefel verbindet sich mit dem Molybdän zu Molybdän(IV)-Disulfid MoS₂, welches nach der Umsetzung direkt als einkristallines 2D-Verbundmaterial bzw. als Monolayer vorliegt.

Alternativ kann, anstatt einen Teil der elektrisch leitfähigen Schicht 31 umzusetzen, auf der elektrisch leitfähigen Schicht 31 ein geeignetes Material, zum Beispiel ein Metall, angeordnet werden. Beispielsweise kann auch hier wieder ein Material aus der Gruppe der Übergangsmetalle auf der elektrisch leitfähigen Schicht 31 angeordnet werden. Mit einem geeigneten Reaktionspartner, z.B. Schwefel, kann dann diese zusätzliche Materialschicht in die Verbindungshalbleiter-Schicht 21 umgewandelt bzw. umgesetzt werden.

Der Vorteil der chemischen Umsetzung im Vergleich zur Abscheidung liegt darin, dass die jeweiligen Schichtdicken der elektrisch leitfähigen Schicht 31 und der Verbindungshalbleiter-Schicht 21 bei der chemischen Umsetzung deutlich geringer ausfallen können als bei der Abscheidung. Beim Abscheiden wird nämlich die Verbindungshalbleiter-Schicht 21 als zusätzliches Material auf der elektrisch leitfähigen Schicht 31 aufgebracht, d.h. die Gesamtschichtdicke des Schichtstapels 20 setzt sich zusammen aus der Schichtdicke der elektrisch leitfähigen Schicht 31 plus der Schichtdicke der darauf angeordneten Verbindungshalbleiter-Schicht 21. Bei der chemischen Umsetzung hingegen wird die elektrisch leitfähige Schicht 31 zumindest teilweise in die Verbindungshalbleiter-Schicht 21 umgewandelt bzw. umgesetzt. Hierbei setzt sich die Gesamtschichtdicke des Schichtstapels 20 demnach lediglich aus der Schichtdicke der ursprünglichen elektrisch leitfähigen Schicht 31 zusammen.

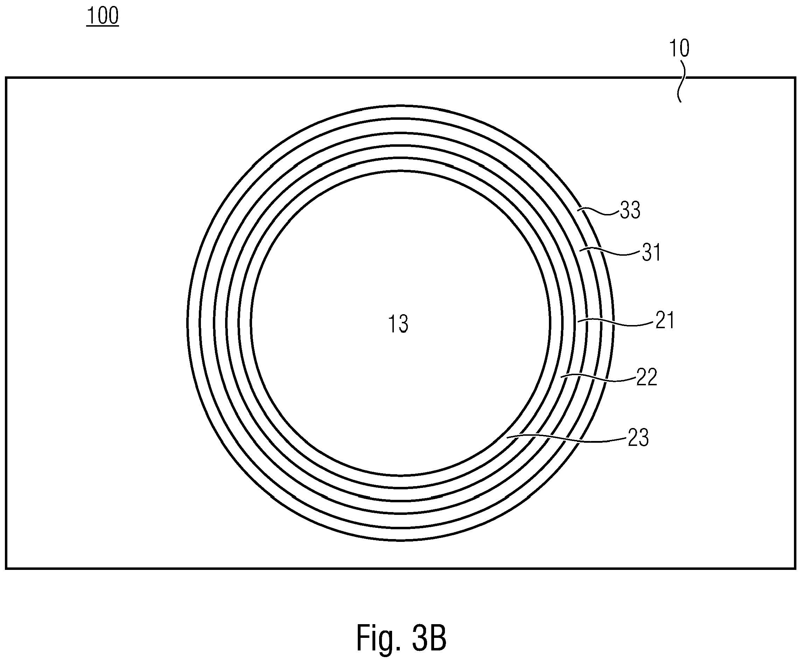

Die Figuren 3A und 3B zeigen ein weiteres Ausführungsbeispiel einer vertikalen Verbindungshalbleiter-Struktur 100. Die hier abgebildete vertikale Verbindungshalbleiter-Struktur 100 weist einen Schichtstapel 20 mit mehreren Schichten auf. Figur 3A zeigt eine seitliche Schnittansicht und Figur 3B zeigt eine Draufsicht.

In diesem Ausführungsbeispiel weist der Schichtstapel 20 eine elektrisch leitfähige Schicht 31 auf. Die elektrisch leitfähige Schicht 31 kann direkt und unmittelbar auf dem Substrat 10 angeordnet sein, zum Beispiel wenn das Substrat 10 nicht-leitende Eigenschaften aufweist. Optional kann eine Isolatorschicht 33 (Dielektrikum) zwischen dem Substrat 10 und der elektrisch leitfähigen Schicht 31 angeordnet sein, z.B. wenn das Substrat 10 leitende Eigenschaften aufweist.

Der Substratstapel 20 kann ferner eine innerhalb der vertikalen Kanalöffnung 13, und entlang der Erstreckungsrichtung der vertikalen Kanalöffnung 13, angeordnete zweite Verbindungshalbleiter-Schicht 22 aufweisen. Die zweite Verbindungshalbleiter-Schicht 22 kann auf der zuvor beschriebenen Verbindungshalbleiter-Schicht 21, die in einem Schichtstapel 20 mit mehreren Schichten auch als eine erste Verbindungshalbleiter-Schicht 21 bezeichnet werden kann, angeordnet und galvanisch mit dieser verbunden sein.

Dabei kann die zweite Verbindungshalbleiter-Schicht 22 auf der der elektrisch leitfähigen Schicht 31 gegenüberliegenden Seite der ersten Verbindungshalbleiter-Schicht 21 angeordnet sein, sodass die erste Verbindungshalbleiter-Schicht 21 zwischen der elektrisch leitfähigen Schicht 31 und der zweiten Verbindungshalbleiter-Schicht 22 angeordnet ist. Die erste Verbindungshalbleiter-Schicht 21 kann demnach also innerhalb der vertikalen Kanalöffnung 13 radial weiter außen angeordnet sein als die zweite Verbindungshalbleiter-Schicht 22. Ebenso kann die elektrisch leitfähige Schicht 31 innerhalb der vertikalen Kanalöffnung 13 radial weiter außen angeordnet sein als die erste Verbindungshalbleiter-Schicht 21 sowie die zweite Verbindungshalbleiter-Schicht 22. Die zweite Verbindungshalbleiter-Schicht 22 kann direkt bzw. unmittelbar auf der ersten Verbindungshalbleiter-Schicht 21 angeordnet sein.

Die zweite Verbindungshalbleiter-Schicht 22 kann ebenfalls eines der zuvor mit Bezug auf die erste Verbindungshalbleiter-Schicht 21 beschriebenen Materialien aufweisen, z.B. ein 2D-Verbundmaterial, und insbesondere ein Material aus der Gruppe der Übergangsmetall-Chalkogenide, wie z.B. MoS₂. Die zweite Verbindungshalbleiter-Schicht 22 kann ebenfalls, wie zuvor mit Bezug auf die erste Verbindungshalbleiter-Schicht 21 beschrieben, mittels Abscheidung oder mittels chemischer Umsetzung auf der ersten Verbindungshalbleiter-Schicht 21 angeordnet werden. Zur chemischen Umsetzung kann beispielsweise ein geeignetes zusätzliches Material, zum Beispiel ein Metall oder Übergangsmetall, auf der ersten Verbindungshalbleiter-Schicht 21 vorabgeschieden werden, welches dann mittels der chemischen Umsetzung in die zweite Verbindungshalbleiter-Schicht 22 umgewandelt bzw. umgesetzt werden kann.

In den Figuren 3A und 3B sind noch weitere Schichten gezeigt. Sofern aber der Schichtstapel 20 zumindest die erste Verbindungshalbleiter-Schicht 21 und die zweite Verbindungshalbleiter-Schicht 22 aufweist, kann die erfindungsgemäße vertikale Verbindungshalbleiter-Struktur 100 als eine innerhalb der vertikalen Kanalöffnung 13 angeordnete Diodenstruktur realisiert werden.

Der Substratstapel 20 kann ferner eine innerhalb der vertikalen Kanalöffnung 13, und entlang der Erstreckungsrichtung der vertikalen Kanalöffnung 13, angeordnete dritte Verbindungshalbleiter-Schicht 23 aufweisen. Die dritte Verbindungshalbleiter-Schicht 23 kann auf der zuvor beschriebenen zweiten Verbindungshalbleiter-Schicht 22 angeordnet und galvanisch mit dieser verbunden sein.

Dabei kann die dritte Verbindungshalbleiter-Schicht 23 auf der der ersten Verbindungshalbleiter-Schicht 21 gegenüberliegenden Seite der zweiten Verbindungshalbleiter-Schicht 22 angeordnet sein, sodass die zweite Verbindungshalbleiter-Schicht 22 zwischen der ersten Verbindungshalbleiter-Schicht 21 und der dritten Verbindungshalbleiter-Schicht 23 angeordnet ist. Die zweite Verbindungshalbleiter-Schicht 22 kann demnach also innerhalb der vertikalen Kanalöffnung 13 radial weiter außen angeordnet sein als die dritte Verbindungshalbleiter-Schicht 23. Ebenso kann die erste Verbindungshalbleiter-Schicht 21 innerhalb der vertikalen Kanalöffnung 13 radial weiter außen angeordnet sein als die zweite Verbindungshalbleiter-Schicht 22 sowie die dritte Verbindungshalbleiter-Schicht 23. Die dritte Verbindungshalbleiter-Schicht 23 kann direkt bzw. unmittelbar auf der zweiten Verbindungshalbleiter-Schicht 22 angeordnet sein.

Die dritte Verbindungshalbleiter-Schicht 23 kann ebenfalls eines der zuvor mit Bezug auf die erste Verbindungshalbleiter-Schicht 21 beschriebenen Materialien aufweisen, z.B. ein 2D-Verbundmaterial, und insbesondere ein Material aus der Gruppe der Übergangsmetall-Chalkogenide, wie z.B. MoS₂. Die dritte Verbindungshalbleiter-Schicht 23 kann ebenfalls, wie zuvor mit Bezug auf die erste Verbindungshalbleiter-Schicht 21 beschrieben, mittels Abscheidung oder mittels chemischer Umsetzung auf der zweiten Verbindungshalbleiter-Schicht 22 angeordnet werden. Zur chemischen Umsetzung kann beispielsweise ein geeignetes zusätzliches Material, zum Beispiel ein Metall oder Übergangsmetall, auf der zweiten Verbindungshalbleiter-Schicht 22 vorabgeschieden werden, welches dann mittels der chemischen Umsetzung in die dritte Verbindungshalbleiter-Schicht 23 umgewandelt bzw. umgesetzt werden kann.

Sofern der Schichtstapel 20 die in den Figuren 3A und 3B gezeigten Verbindungshalbleiter-Schichten, d.h. die erste Verbindungshalbleiter-Schicht 21, die zweite Verbindungshalbleiter-Schicht 22 sowie die dritte Verbindungshalbleiter-Schicht 23 aufweist, kann die erfindungsgemäße vertikale Verbindungshalbleiter-Struktur 100 als eine innerhalb der vertikalen Kanalöffnung 13 angeordnete Transistorstruktur realisiert werden. Genauer gesagt handelt es sich hierbei um einen vertikalen Bipolartransistor.

Wie in den Figuren 3A und 3B zu sehen ist, können sich die elektrisch leitfähige Schicht 31 und die darauf angeordnete erste Verbindungshalbleiter-Schicht 21 entlang der Erstreckungsrichtung der im Wesentlichen zylinderförmig ausgestalteten Kanalöffnung 13 erstrecken. Dies gilt im Übrigen für alle innerhalb der vertikalen Kanalöffnung 13 angeordneten Schichten, wie z.B. für die oben beschriebenen zweiten und dritten Verbindungshalbleiter-Schichten 22, 23.

Eine oder mehrere der innerhalb der vertikalen Kanalöffnung 13 angeordneten Schichten 21, 22, 23, 31, 32, oder der gesamte Schichtstapel 20, können sich in vertikaler Richtung vollständig zwischen der ersten Hauptoberfläche 11 des Substrats 10 und der zweiten Hauptoberfläche 12 des Substrats 10 erstrecken. Es ist aber auch denkbar, dass sich ein oder mehrere Schichten des Schichtstapels 20 in vertikaler Richtung nur abschnittsweise zwischen der ersten Hauptoberfläche 11 des Substrats 10 und der zweiten Hauptoberfläche 12 des Substrats 10 erstrecken.

Jede der innerhalb der vertikalen Kanalöffnung 13 angeordneten Schichten 21, 22, 23, 31, 32 kann in Form eines Hohlzylinders ausgestaltet sein. Der Schichtstapel 20 weist somit mehrere hohlzylinderförmig ausgestaltete Schichten 21, 22, 23, 31, 32 auf, die in radialer Richtung ineinander gestapelt sein können, so wie dies in der in Figur 3B gezeigten Draufsicht zu sehen ist.

Zumindest die in radialer Richtung am weitesten außenliegende Schicht des Schichtstapels 20 (in diesem Beispiel die Isolatorschicht 33) kann direkt und unmittelbar auf der lateral umlaufenden Wandung der zylinderförmigen vertikalen Kanalöffnung 13 angeordnet sein. Die weiteren Schichten können dann der Reihe nach folgen, und zwar in radialer Richtung nach innen zu einem Zentrum 40 der Kanalöffnung 13 hin.

Das heißt, der Schichtstapel 20 kann als erste Schicht eine hohlzylinderförmig ausgestaltete elektrisch leitfähige Schicht 31 aufweisen. Der Schichtstapel 20 kann als zweite Schicht eine hohlzylinderförmig ausgestaltete erste Verbindungshalbleiter-Schicht 21 aufweisen, die in radialer Richtung innerhalb der hohlzylinderförmig ausgestalteten elektrisch leitfähigen Schicht 31 angeordnet ist. Der Schichtstapel 20 kann als dritte Schicht eine hohlzylinderförmig ausgestaltete zweite Verbindungshalbleiter-Schicht 22 aufweisen, die in radialer Richtung innerhalb der hohlzylinderförmig ausgestalteten ersten Verbindungshalbleiter-Schicht 21 angeordnet ist. Der Schichtstapel 20 kann als vierte Schicht eine hohlzylinderförmig ausgestaltete dritte Verbindungshalbleiter-Schicht 23 aufweisen, die in radialer Richtung innerhalb der hohlzylinderförmig ausgestalteten zweiten Verbindungshalbleiter-Schicht 22 angeordnet ist.

Es ist außerdem denkbar, dass zwischen den einzelnen Schichten 21, 22, 23, 31, 33 weitere Schichten angeordnet sind, zum Beispiel Metallisierungsschichten.

Der gesamte Schichtstapel 20 kann also in Form eines mehrere Schichten aufweisenden Hohlzylinders ausgestaltet sein, sodass sich der ursprüngliche Durchmesser D (Figur 3A) der Kanalöffnung 13 um die (in radialer Richtung zu bemessende) Schichtdicke des Schichtstapels 20 reduziert. Der reduzierte Durchmesser der den Schichtstapel 20 beinhaltenden Kanalöffnung 13 ist mit dem Bezugszeichen d referenziert.

Der Schichtstapel 20 kann daher auch als ein vertikaler Schichtstapel bezeichnet werden. Dieser weist mehrere Schichten auf, die in radialer Richtung ineinander gestapelt sein können. Der gesamte Schichtstapel 20 erstreckt sich dabei in axialer Richtung bezogen auf die vertikale Kanalöffnung 13, d.h. in Erstreckungsrichtung der vertikalen Kanalöffnung 13.

Wie eingangs erwähnt, kann die erfindungsgemäße vertikale Verbindungshalbleiter-Struktur 100 als eine innerhalb der vertikalen Kanalöffnung 13 angeordnete Diodenstruktur oder Transistorstruktur realisiert werden.

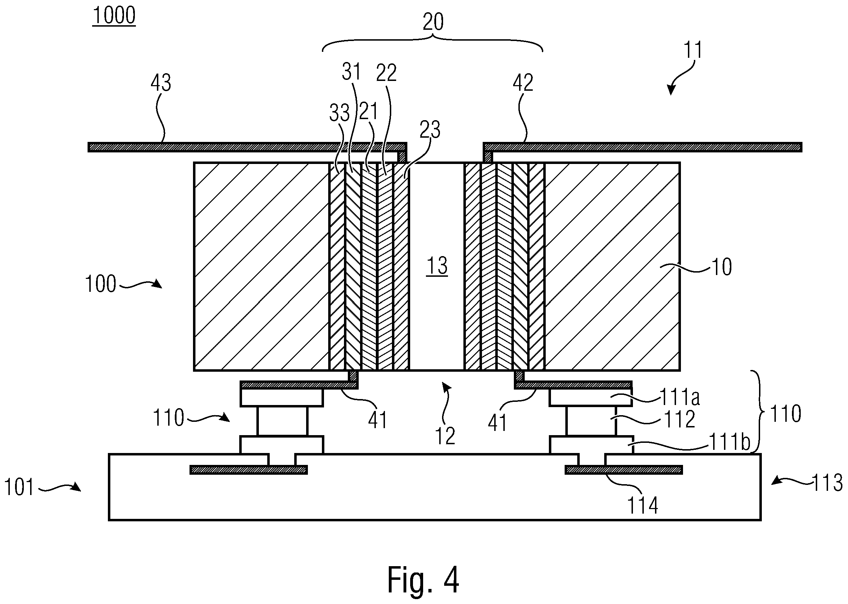

Figur 4 zeigt ein Ausführungsbeispiel einer als Transistor ausgeführten erfindungsgemäßen vertikalen Verbindungshalbleiter-Struktur 100. Hierbei kann es sich um einen vertikalen Bipolartransistor handeln. Dieses Ausführungsbeispiel entspricht im Wesentlichen den zuvor unter Bezugnahme auf die Figuren 3A und 3B diskutierten Ausführungsbeispiel, weshalb im Folgenden nur die Unterschiede erläutert werden.

Die erste, zweite und dritte Verbindungshalbleiter-Schichten 21, 22, 23 können jeweils separat voneinander kontaktiert werden. In dem in Figur 4 gezeigten Ausführungsbeispiel können die zweite Verbindungshalbleiter-Schicht 22 und die dritte Verbindungshalbleiter-Schicht 23 direkt kontaktiert sein, zum Beispiel mittels direkt angeschlossenen elektrischen Leitern 42, 43 bzw. Zuleitungen.

Die erste Verbindungshalbleiter-Schicht 21 kann beispielsweise indirekt kontaktiert sein, zum Beispiel über die elektrisch leitfähige Schicht 31. Die erste Verbindungshalbleiter-Schicht 21 kann in diesem Fall kontaktlos ausgeführt sein, d.h. sie weist keinen direkten Kontakt bzw. Anschluss auf. Die elektrisch leitfähige Schicht 31 kann hingegen direkt kontaktiert sein, zum Beispiel mittels einem direkt angeschlossenen elektrischen Leiter 41. Die elektrisch leitfähige Schicht 31 wird also kontaktiert und gibt ihre Ladungsträger großflächig, und vorzugsweise vollflächig, auf die erste Verbindungshalbleiter-Schicht 21 ab. Die elektrisch leitfähige Schicht 31 kann daher auch als Anschluss-Schicht zum Anschließen der kontaktlosen Verbindungshalbleiter-Schicht 21 bezeichnet werden.

Die drei ineinander angeordneten Verbindungshalbleiter-Schichten 21, 22, 23 können drei abwechselnde p-n-Übergänge bilden, um die Transistorstruktur zu realisieren. Je nach Anschluss-Typ kann beispielsweise die erste Verbindungshalbleiter-Schicht 21 eine Emitterschicht des vertikalen Bipolartransistors 100 bereitstellen. Die zweite Verbindungshalbleiter-Schicht 22 kann eine Basis-Schicht des vertikalen Bipolartransistors 100 bereitstellen. Und die dritte Verbindungshalbleiter-Schicht 23 kann eine Kollektorschicht des vertikalen Bipolartransistors 100 bereitstellen. Die Emitterschicht und die Kollektorschicht können auch vertauscht sein. Im Regelfall wird die Emitterschicht eine höhere Ladungsträgerdichte aufweisen als die Basis-Schicht, und die Basis-Schicht wird ihrerseits wiederum eine höhere Ladungsträgerdichte aufweisen als die Kollektorschicht.

In Figur 4 ist die als Transistorstruktur ausgestaltete erfindungsgemäße vertikale Verbindungshalbleiter-Struktur 100 als Teil eines 3D-Systems 1000 dargestellt. Hierfür ist die erfindungsgemäße vertikale Verbindungshalbleiter-Struktur 100 in vertikaler Richtung mit einer zusätzlichen separaten elektronischen Bauelementstruktur 101 verbunden. Die vertikale Kanalöffnung 13 kann hierbei als vertikale Durchkontaktierung dienen, um beispielsweise die in dem 3D-Halbleiterbauelement 1000 angeordneten Bauelemente-Strukturen 100, 101 galvanisch miteinander zu verbinden.

Die zusätzliche separate elektronische Bauelementstruktur 101 kann, wie abgebildet, der zweiten Hauptoberfläche 12 des Substrats 10 gegenüberliegend angeordnet sein. Alternativ oder zusätzlich kann die zusätzliche separate elektronische Bauelementstruktur 101, oder eine weitere (nicht abgebildete) zusätzliche separate elektronische Bauelementstruktur, der ersten Hauptoberfläche 11 des Substrats 10 gegenüberliegend angeordnet sein.

Die in Figur 4 beispielhaft der zweiten Hauptoberfläche 12 des Substrats 10 gegenüberliegend angeordnete zusätzliche separate elektronische Bauelementstruktur 101 kann ihrerseits eine hierin beschriebene erfindungsgemäße vertikale Verbindungshalbleiter-Struktur 100 sein. Alternativ kann die zusätzliche separate elektronische Bauelementstruktur 101, wie in Figur 4 abgebildet, ein in Planartechnik hergestelltes 2D-System sein. Die zusätzliche separate elektronische Bauelementstruktur 101 kann beispielsweise einen IC aufweisen, der wiederum mit Schaltungsstrukturen der erfindungsgemäßen vertikalen Verbindungshalbleiter-Struktur 100 zusammenwirkt, um ein 3D-IC zu bilden. Alternativ kann die zusätzliche separate elektronische Bauelementstruktur 101 ein eigenständiges Bauelement, zum Beispiel einen Chip, aufweisen, der zusammen mit der erfindungsgemäßen vertikalen Verbindungshalbleiter-Struktur 100 ein 3D-Package bildet.

Die erfindungsgemäße vertikale Verbindungshalbleiter-Struktur 100 und die zusätzliche separate elektronische Bauelementstruktur 101 können mittels einem Kontaktierungsabschnitt 110 galvanisch, und gegebenenfalls auch mechanisch, miteinander verbunden werden. Diese Verbindung kann beispielsweise mittels eines sogenannten Intermetallic Compound (IMC) Verbindungsverfahrens realisiert werden. Beispielsweise kann der Kontaktierungsabschnitt 110 einen oder mehrere Metallpads 111a aufweisen. Auch die zusätzliche separate elektronische Bauelementstruktur 101 kann ihrerseits einen oder mehrere Metallpads 111b aufweisen. Zwischen den Metallpads 111a, 111b können Kontaktpads 112 angeordnet sein, um die Metallpads 111a, 111b galvanisch und/oder mechanisch miteinander zu verbinden. Die Metallpads 111a, 111b können beispielsweise Kupfer aufweisen, und die Kontaktpads 112 können beispielsweise Kupfer und/oder Zinn aufweisen.

Wie in Figur 4 zu sehen ist, kann die zusätzliche separate elektronische Bauelementstruktur 101 beispielsweise ein Substrat 113 mit integrierten Metallisierungs-Layern 114 aufweisen. Die Metallisierungs-Layer 114 können mittels dem Kontaktierungsabschnitt 110 mit der erfindungsgemäßen vertikalen Verbindungshalbleiter-Struktur 100, und insbesondere mit der Verbindungshalbleiter-Schicht 21, galvanisch verbunden sein.

In dem in Figur 4 abgebildeten Ausführungsbeispiel ist der Kontaktierungsabschnitt 110 zwischen der zweiten Hauptoberfläche 12 des Substrats 10 und der zusätzlichen separaten elektronischen Bauelementstruktur 101 angeordnet. Alternativ oder zusätzlich ist es denkbar, dass die zusätzliche separate elektronische Bauelementstruktur 101 oder eine weitere zusätzliche separate elektronische Bauelementstruktur (nicht dargestellt) mittels eines geeigneten Kontaktierungsabschnitts 110 der ersten Hauptoberfläche 11 des Substrats 10 gegenüberliegend angeordnet wird. In diesem Fall wäre die erfindungsgemäße vertikale Verbindungshalbleiter-Struktur 100 zwischen zwei zusätzlichen separaten elektronischen Bauelementstrukturen angeordnet, sodass im Ergebnis ein dreidimensionales elektronisches Halbleiter-Bauelement 1000 (z.B. 3D-IC oder 3D-Package) gebildet wird.

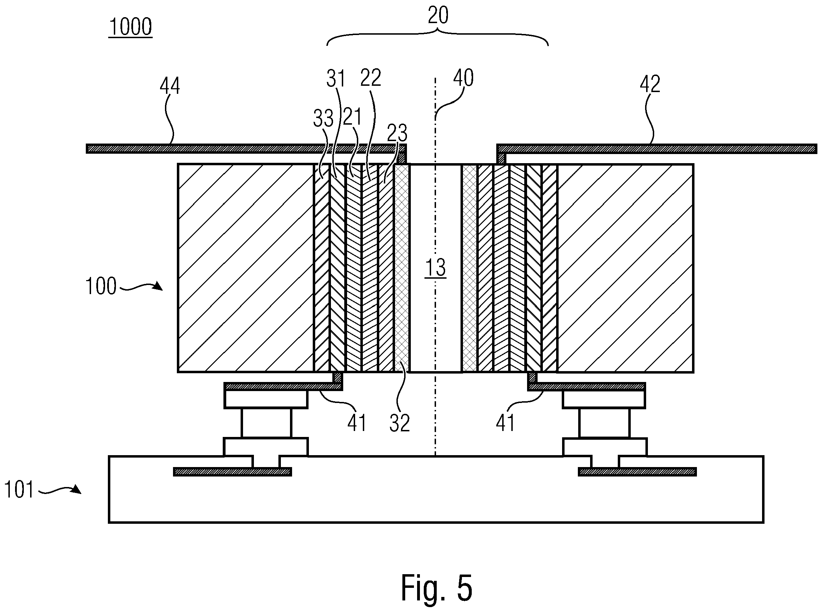

Figur 5 zeigt ein weiteres Ausführungsbeispiel einer erfindungsgemäßen vertikalen Verbindungshalbleiter-Struktur 100 als Teil eines dreidimensionalen elektronischen Halbleiter-Bauelements 1000. Dieses Ausführungsbeispiel entspricht im Wesentlichen dem zuvor unter Bezugnahme auf Figur 4 diskutierten Ausführungsbeispiel, weshalb im Folgenden nur die Unterschiede erläutert werden.

Bei dem in Figur 5 abgebildeten Ausführungsbeispiel weist der Schichtstapel 20 eine zweite elektrisch leitfähige Schicht 32 auf. Diese zweite elektrisch leitfähige Schicht 32 ist innerhalb der vertikalen Kanalöffnung 13, und entlang der Erstreckungsrichtung der vertikalen Kanalöffnung 13, angeordnet. Für diese zweite elektrisch leitfähige Schicht 32 gilt im Übrigen alles, was zuvor unter Bezugnahme auf die in den Figuren 3A und 3B diskutierten Schichten erläutert wurde.

Die zweite elektrisch leitfähige Schicht 32 kann auf der dritten Verbindungshalbleiter-Schicht 23 angeordnet und galvanisch mit dieser verbunden sein. Die zweite elektrisch leitfähige Schicht 32 kann auf der der zweiten Verbindungshalbleiter-Schicht 22 gegenüberliegenden Seite der dritten Verbindungshalbleiter-Schicht 23 angeordnet sein und die radial innenliegendste Schicht bilden. Das heißt, die zweite elektrisch leitfähige Schicht 32 kann, in radialer Richtung, die innerste, d.h. die am nächsten zum Zentrum 40 der Kanalöffnung 13 angeordnete, Schicht des Schichtstapels 20 bilden. In dieser Anordnung kann demnach die zweite elektrisch leitfähige Schicht 32 auf der der zweiten Verbindungshalbleiter-Schicht 22 gegenüberliegenden Seite der dritten Verbindungshalbleiter-Schicht 23 angeordnet sein, sodass die dritte Verbindungshalbleiter-Schicht 23 zwischen der zweiten Verbindungshalbleiter-Schicht 22 und der zweiten elektrisch leitfähigen Schicht 32 angeordnet ist.

Die zweite elektrisch leitfähige Schicht 32 ermöglicht eine vollflächige Kontaktierung der dritten Verbindungshalbleiter-Schicht 23. Die zweite elektrisch leitfähige Schicht 32 kann daher auch als Anschluss-Schicht zum Anschließen der dritten Verbindungshalbleiter-Schicht 23 bezeichnet werden.

Das heißt, die erste Verbindungshalbleiter-Schicht 21 sowie die zweite Verbindungshalbleiter-Schicht 22 wären nach wie vor direkt kontaktiert, zum Beispiel mittels elektrischen Leitern 41, 42. Die dritte Verbindungshalbleiter-Schicht 23 wäre hingegen nicht direkt kontaktiert. Stattdessen kann die zweite elektrisch leitfähige Schicht 32 direkt kontaktiert sein, zum Beispiel mittels einem elektrischen Leiter 44, und die dritte Verbindungshalbleiter-Schicht 23 kann dann wiederum indirekt über die zweite elektrisch leitfähige Schicht 32 kontaktiert sein.

Das oben gesagte gilt im Falle der in Figur 5 abgebildeten Transistorstruktur mit drei Verbindungshalbleiter-Schichten 21, 22, 23. Sofern die erfindungsgemäße Verbindungshalbleiter-Struktur 100 als eine zwei Verbindungshalbleiter-Schichten 21, 22 aufweisende Diodenstruktur ausgestaltet sein sollte, gilt all das oben gesagte ebenso, wobei die zweite Verbindungshalbleiter-Schicht 22 die oben beschriebene dritte Verbindungshalbleiter-Schicht 23 ersetzen würde. Das heißt, die zweite elektrisch leitfähige Schicht 32 könnte demnach auf der zweiten Verbindungshalbleiter-Schicht 22 angeordnet sein.

Die zweite elektrisch leitfähige Schicht 32 kann direkt und unmittelbar auf der zweiten Verbindungshalbleiter-Schicht 22 bzw. auf der dritten Verbindungshalbleiter-Schicht 23 angeordnet sein.

Obwohl die obigen Aspekte im Zusammenhang mit der erfindungsgemäßen vertikalen Verbindungshalbleiter-Struktur 100 beschrieben wurden, versteht es sich, dass diese Aspekte auch eine Beschreibung des entsprechenden Verfahrens zum Herstellen einer erfindungsgemäßen vertikalen Verbindungshalbleiter-Struktur 100 darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Nachfolgend soll die Erfindung nochmals in anderen Worten kurz zusammengefasst werden:
Die vorliegende Erfindung betrifft, unter anderem, ein Verfahren zur Herstellung von dreidimensionalen elektronischen Systemen 1000, und insbesondere von dreidimensionalen integrierten Schaltungen. Unter einer dreidimensionalen Integration wird die vertikale Verbindung (mechanisch und elektrisch) von Bauelementen verstanden. Die Vorteile eines dreidimensional integrierten elektronischen Systems 1000 sind u. a. die erreichbaren höheren Packungsdichten und Schaltgeschwindigkeiten (bedingt durch kürzere Leitungswege) gegenüber zweidimensionalen Systemen (Planartechnik).

Das erfindungsgemäße Verfahren realisiert die dreidimensionale Verbindung von vertikalen Verbindungshalbleitern 21, 22, 23 in Substratdurchkontaktierungen 13 des einen Substrats 10 mit den Bauelementen 101 eines anderen Substrates und ermöglicht somit eine wesentliche Integrationsdichteerhöhung dreidimensional integrierter Bauelemente-Systeme 1000. Die Substratdurchkontaktierungen 13 können gegenüber dem Substrat 10 elektrisch isolierte Durchkontaktierungen (TSV - Through Substrate Via) sein.

Die vorliegende Erfindung betrifft, unter anderem, ein Verfahren zur Herstellung von dreidimensionalen elektronischen Systemen 1000, bei dem zunächst eine vertikale Kanalöffnung 13 in einem Substrat 10 mit einer optionalen gegenüber dem Substrat 10 elektrisch isolierenden Schicht 33 erzeugt wird. Sodann kann eine elektrisch leitende Schicht 31 in der vertikalen Seitenwand der Kanalöffnung 13 erzeugt werden. Es kann das Erzeugen einer ersten Halbleiter-Schicht 21 folgen, die mit der elektrisch leitenden Schicht 31 elektrisch leitend verbunden ist, sowie das Erzeugen einer zweiten Halbleiter-Schicht 22, die mit der ersten Halbleiter-Schicht 21 elektrisch leitend verbunden ist, und das Erzeugen einer dritten Halbleiter-Schicht 23, die mit der zweiten Halbleiter-Schicht 22 elektrisch leitend verbunden ist, wobei mindestens eine der Halbleiterschichten 21, 22, 23 als Verbindungshalbleiter ausgeführt ist.

Die elektrisch leitende und - ohne Einschränkung der Allgemeinheit - mechanische Verbindung kann über die Struktur 110 zum unteren Substrat / Bauelement 101 realisiert werden und kann hierbei - ohne Einschränkung der Allgemeinheit - mittels Intermetallic Compound (IMC) Verbindungsverfahren erzeugt werden.

Das erfindungsgemäße Verfahren realisiert somit die dreidimensionale Verbindung der vertikalen Verbindungshalbleiter 100 in den Substratdurchkontaktierungen 13 des einen Substrats 10 mit den Bauelementen 101 eines anderen Substrats und ermöglicht somit höchstdicht integrierte Bauelemente-Systeme 1000.

Gemäß einem Aspekt der Erfindung wird ein Verfahren zum Verbinden von mindestens zwei elektrischen Komponenten vorgeschlagen, mit den folgenden Schritten:
Bereitstellen eines Substrates 10,
Erzeugen einer vertikalen Kanalöffnung 13 durch das Substrat 10,
Erzeugen einer gegenüber dem Substrat 10 elektrisch isolierenden Schicht 33 auf der vertikalen Seitenwand der vertikalen Kanalöffnung 13,
Erzeugen einer elektrisch leitenden Schicht 31 auf der elektrisch isolierenden Schicht 33,
Erzeugen einer ersten Halbleiter-Schicht 21, die mit der elektrisch leitenden Schicht 31 elektrisch leitend verbunden ist,
Erzeugen einer zweiten Halbleiter-Schicht 22, die mit der ersten Halbleiter-Schicht 21 elektrisch leitend verbunden ist,
Erzeugen einer dritten Halbleiter-Schicht 23, die mit der zweiten Halbleiter-Schicht 22 elektrisch leitend verbunden ist, und
Erzeugen von Vorrichtungen 110 zum elektrisch leitenden Verbinden des Schichtstapels 20 mit mindestens einer Bauelemente-Struktur 101,
wobei mindestens eine der Halbleiter-Schichten 21, 22 oder 23 als Verbindungshalbleiter-Schicht ausgeführt ist.

Gemäß einem weiteren Aspekt wird mindestens eine der Verbindungshalbleiter-Schichten 21, 22, 23 durch Abscheidung erzeugt.

Gemäß einem weiteren Aspekt wird mindestens eine der Verbindungshalbleiter-Schichten 21, 22, 23 lokal durch chemische Reaktion erzeugt.

Gemäß einem weiteren Aspekt wird zusätzlich eine elektrisch leitende Schicht 32 erzeugt, die mit der dritten Halbleiter-Schicht 23 elektrisch leitend verbunden ist.

Ferner wird eine, im Folgenden auch als mikroelektronische Anschlussvorrichtung bezeichnete vertikale Verbindungshalbleiter-Struktur 100, vorgeschlagen, aufweisend:
ein Substrat 10,
eine vertikale Kanalöffnung 13 durch das Substrat 10,
eine gegenüber dem Substrat 10 elektrisch isolierenden Schicht 33 auf der vertikalen Seitenwand der vertikalen Kanalöffnung 13,
eine elektrisch leitende Schicht 31 auf der elektrisch isolierenden Schicht 33,
eine erste Halbleiter-Schicht 21, die mit der elektrisch leitenden Schicht 31 elektrisch leitend verbunden ist,
eine zweite Halbleiter-Schicht 22, die mit der ersten Halbleiter-Schicht 21 elektrisch leitend verbunden ist,
eine dritte Halbleiter-Schicht 23, die mit der zweiten Halbleiter-Schicht 22 elektrisch leitend verbunden ist,
Vorrichtungen 110 zum elektrisch leitenden Verbinden des Schichtstapels 20 mit mindestens einer Bauelemente-Struktur 101,
wobei mindestens eine der Halbleiter-Schichten 21, 22, 23 als Verbindungshalbleiter-Schicht ausgeführt ist.

Die vorliegende Erfindung kann ferner in Form der folgenden Ausführungsbeispiele realisierbar sein:
1. Vertikale Verbindungshalbleiter-Struktur (100), aufweisend:
   ein Substrat (10) mit einer ersten Hauptoberfläche (11) und einer gegenüberliegenden zweiten Hauptoberfläche (12),
   eine vertikale Kanalöffnung (13), die sich zwischen der ersten Hauptoberfläche (11) und der zweiten Hauptoberfläche (12) vollständig durch das Substrat (10) hindurch erstreckt,
   einen innerhalb der vertikalen Kanalöffnung (13) angeordneten Schichtstapel (20),
   wobei der Schichtstapel (20) eine innerhalb der vertikalen Kanalöffnung (13) angeordnete elektrisch leitfähige Schicht (31) und eine innerhalb der vertikalen Kanalöffnung (13) angeordnete Verbindungshalbleiter-Schicht (21) aufweist,
   wobei die Verbindungshalbleiter-Schicht (21) einen auf der elektrisch leitfähigen Schicht (31) angeordneten und mit der elektrisch leitfähigen Schicht (31) galvanisch verbundenen Verbindungshalbleiter aufweist.
2. Vertikale Verbindungshalbleiter-Struktur (100) nach Ausführungsbeispiel 1,
   wobei die Verbindungshalbleiter-Schicht (21) einen monokristallinen Verbindungs-Halbleiter aufweist.
3. Vertikale Verbindungshalbleiter-Struktur (100) nach Ausführungsbeispiel 1 oder 2,
   wobei die Verbindungshalbleiter-Schicht (21) mindestens ein 2D-Verbundmaterial aufweist.
4. Vertikale Verbindungshalbleiter-Struktur (100) nach einem der vorhergehenden Ausführungsbeispiele,
   wobei die Verbindungshalbleiter-Schicht (21) mindestens eine Elementkombination aus der Gruppe der Übergangsmetalle und der Gruppe der Chalkogeniden aufweist.
5. Vertikale Verbindungshalbleiter-Struktur (100) nach einem der vorhergehenden Ausführungsbeispiele,
   wobei die elektrisch leitfähige Schicht (31) innerhalb der vertikalen Kanalöffnung (13) direkt und unmittelbar auf dem Substrat (10) angeordnet ist, oder
   wobei innerhalb der vertikalen Kanalöffnung (13) eine Isolatorschicht (33) zwischen dem Substrat (10) und der elektrisch leitfähigen Schicht (31) angeordnet ist.
6. Vertikale Verbindungshalbleiter-Struktur (100) nach einem der vorhergehenden Ausführungsbeispiele,
   wobei die Verbindungshalbleiter-Schicht (21) mittels Abscheidung auf der elektrisch leitfähigen Schicht (31) angeordnet ist.
7. Vertikale Verbindungshalbleiter-Struktur (100) nach einem der Ausführungsbeispiele 1 bis 5,
   wobei die Verbindungshalbleiter-Schicht (21) mittels chemischer Umsetzung aus zumindest einem Teil der elektrisch leitfähigen Schicht (31) gebildet ist.
8. Vertikale Verbindungshalbleiter-Struktur (100) nach einem der vorhergehenden Ausführungsbeispiele,
   wobei der Schichtstapel (20) eine innerhalb der vertikalen Kanalöffnung (13) angeordnete zweite Verbindungshalbleiter-Schicht (22) aufweist, die auf der Verbindungshalbleiter-Schicht (21) angeordnet und galvanisch mit dieser verbunden ist,
   wobei die zweite Verbindungshalbleiter-Schicht (22) auf der der elektrisch leitfähigen Schicht (31) gegenüberliegenden Seite der Verbindungshalbleiter-Schicht (21) angeordnet ist, sodass die Verbindungshalbleiter-Schicht (21) zwischen der elektrisch leitfähigen Schicht (31) und der zweiten Verbindungshalbleiter-Schicht (22) angeordnet ist.
9. Vertikale Verbindungshalbleiter-Struktur (100) nach Ausführungsbeispiel 8,
   wobei die zweite Verbindungshalbleiter-Schicht (22) mindestens ein 2D-Verbundmaterial aufweist.
10. Vertikale Verbindungshalbleiter-Struktur (100) nach einem der Ausführungsbeispiele 8 oder 9,
   wobei der Schichtstapel (20) eine innerhalb der vertikalen Kanalöffnung (13) angeordnete dritte Verbindungshalbleiter-Schicht (23) aufweist, die auf der zweiten Verbindungshalbleiter-Schicht (22) angeordnet und galvanisch mit dieser verbunden ist,
   wobei die dritte Verbindungshalbleiter-Schicht (23) auf der der Verbindungshalbleiter-Schicht (21) gegenüberliegenden Seite der zweiten Verbindungshalbleiter-Schicht (22) angeordnet ist, sodass die zweite Verbindungshalbleiter-Schicht (22) zwischen der Verbindungshalbleiter-Schicht (21) und der dritten Verbindungshalbleiter-Schicht (23) angeordnet ist.
11. Vertikale Verbindungshalbleiter-Struktur (100) nach Ausführungsbeispiel 10,
   wobei die dritte Verbindungshalbleiter-Schicht (23) mindestens ein 2D-Verbundmaterial aufweist.
12. Vertikale Verbindungshalbleiter-Struktur (100) nach Ausführungsbeispiel 10 oder 11,
   wobei der Schichtstapel (20) eine innerhalb der vertikalen Kanalöffnung (13) angeordnete zweite elektrisch leitfähige Schicht (32) aufweist, die auf der dritten Verbindungshalbleiter-Schicht (23) angeordnet und galvanisch mit dieser verbunden ist,
   wobei die zweite elektrisch leitfähige Schicht (32) auf der der zweiten Verbindungshalbleiter-Schicht (22) gegenüberliegenden Seite der dritten Verbindungshalbleiter-Schicht (23) angeordnet ist, sodass die dritte Verbindungshalbleiter-Schicht (23) zwischen der zweiten Verbindungshalbleiter-Schicht (22) und der zweiten elektrisch leitfähigen Schicht (23) angeordnet ist.
13. Dreidimensionales elektronisches Halbleiter-Bauelement (1000) mit mindestens einer vertikalen Verbindungshalbleiter-Struktur (100) gemäß einem der vorhergehenden Ausführungsbeispiele,
   wobei der ersten und/oder der zweiten Hauptoberfläche (11, 12) des Substrats (10) gegenüberliegend eine zusätzliche separate elektronische Bauelementstruktur (101) angeordnet ist, die mittels einem Kontaktierungsabschnitt (110) mechanisch und/oder galvanisch mit der vertikalen Verbindungshalbleiter-Struktur (100) verbunden ist.
14. Verfahren zum Herstellen einer vertikalen Verbindungshalbleiter-Struktur (100), wobei das Verfahren die folgenden Schritte aufweist:
   Bereitstellen (201) eines Substrats (10) mit einer ersten Hauptoberfläche (11) und einer gegenüberliegenden zweiten Hauptoberfläche (12),
   Strukturieren (202) einer vertikalen Kanalöffnung (13), die sich zwischen der ersten Hauptoberfläche (11) und der zweiten Hauptoberfläche (12) vollständig durch das Substrat (10) hindurch erstreckt,
   Erzeugen (203) eines Schichtstapels (20) innerhalb der vertikalen Kanalöffnung (13), wobei der Schritt des Erzeugens des Schichtstapels (20) beinhaltet:
      Anordnen (203a) einer elektrisch leitfähigen Schicht (31) innerhalb der vertikalen Kanalöffnung (13), und
      Anordnen (203b) einer Verbindungshalbleiter-Schicht (21) innerhalb der vertikalen Kanalöffnung (13),
      wobei die Verbindungshalbleiter-Schicht (21) auf der elektrisch leitfähigen Schicht (31) angeordnet und mit der elektrisch leitfähigen Schicht (31) galvanisch verbunden wird.
15. Verfahren nach Ausführungsbeispiel 14,
   wobei der Schritt (203b) des Anordnens der Verbindungshalbleiter-Schicht (21) beinhaltet, dass ein monokristalliner Verbindungs-Halbleiter auf der elektrisch leitfähigen Schicht (31) angeordnet wird.
16. Verfahren nach Ausführungsbeispiel 14 oder 15,
   wobei der Schritt (203b) des Anordnens der Verbindungshalbleiter-Schicht (21) beinhaltet, dass mindestens ein 2D-Verbundmaterial auf der elektrisch leitfähigen Schicht (31) angeordnet wird.
17. Verfahren nach einem der Ausführungsbeispiele 14 bis 16,
   wobei der Schritt (203b) des Anordnens der Verbindungshalbleiter-Schicht (21) beinhaltet, dass mindestens eine Elementkombination aus der Gruppe der Übergangsmetalle und aus der Gruppe der Chalkogeniden auf der elektrisch leitfähigen Schicht (31) angeordnet wird.
18. Verfahren nach einem der Ausführungsbeispiele 14 bis 17,
   wobei die elektrisch leitfähige Schicht (31) innerhalb der vertikalen Kanalöffnung (13) direkt und unmittelbar auf dem Substrat (10) angeordnet wird, oder
   wobei innerhalb der vertikalen Kanalöffnung (13) eine Isolatorschicht (33) zwischen dem Substrat (10) und der elektrisch leitfähigen Schicht (31) angeordnet wird.
19. Verfahren nach einem der Ausführungsbeispiele 14 bis 18,
   wobei der Schritt (203b) des Anordnens der Verbindungshalbleiter-Schicht (21) beinhaltet, dass die Verbindungshalbleiter-Schicht (21) unter Anwendung eines Abscheideverfahrens auf der elektrisch leitfähigen Schicht (31) abgeschieden wird.
20. Verfahren nach einem der Ausführungsbeispiele 14 bis 18,
   wobei die Verbindungshalbleiter-Schicht (21) mittels chemischer Umsetzung aus zumindest einem Teil der elektrisch leitfähigen Schicht (31) gebildet wird.
21. Verfahren nach einem der Ausführungsbeispiele 14 bis 20,
   wobei der Schritt (203) des Erzeugens des Schichtstapels (20) ferner beinhaltet:
   Anordnen einer zweiten Verbindungshalbleiter-Schicht (22) innerhalb der vertikalen Kanalöffnung (13), wobei die zweite Verbindungshalbleiter-Schicht (22) auf der Verbindungshalbleiter-Schicht (21) angeordnet und galvanisch mit dieser verbunden wird, und
   wobei die zweite Verbindungshalbleiter-Schicht (22) auf der der elektrisch leitfähigen Schicht (31) gegenüberliegenden Seite der Verbindungshalbleiter-Schicht (21) angeordnet wird, sodass die Verbindungshalbleiter-Schicht (21) zwischen der elektrisch leitfähigen Schicht (31) und der zweiten Verbindungshalbleiter-Schicht (22) angeordnet ist.
22. Verfahren nach Ausführungsbeispiel 21,
   wobei die zweite Verbindungshalbleiter-Schicht (22) mindestens ein 2D-Verbundmaterial aufweist.
23. Verfahren nach einem der Ausführungsbeispiele 21 oder 22,
   wobei der Schritt (203) des Erzeugens des Schichtstapels (20) ferner beinhaltet:
   Anordnen einer dritten Verbindungshalbleiter-Schicht (23) innerhalb der vertikalen Kanalöffnung (13), wobei die dritte Verbindungshalbleiter-Schicht (23) auf der zweiten Verbindungshalbleiter-Schicht (22) angeordnet und galvanisch mit dieser verbunden wird, und
   wobei die dritte Verbindungshalbleiter-Schicht (23) auf der der ersten Verbindungshalbleiter-Schicht (21) gegenüberliegenden Seite der zweiten Verbindungshalbleiter-Schicht (22) angeordnet wird, sodass die zweite Verbindungshalbleiter-Schicht (22) zwischen der Verbindungshalbleiter-Schicht (21) und der dritten Verbindungshalbleiter-Schicht (23) angeordnet ist.
24. Verfahren nach Ausführungsbeispiel 23,
   wobei die dritte Verbindungshalbleiter-Schicht (23) mindestens ein 2D-Verbundmaterial aufweist.
25. Verfahren nach Ausführungsbeispiel 23 oder 24,
   wobei der Schritt (203) des Erzeugens des Schichtstapels (20) ferner beinhaltet:
   Anordnen einer zweiten elektrisch leitfähigen Schicht (32) innerhalb der vertikalen Kanalöffnung (13), wobei die zweite elektrisch leitfähige Schicht (32) auf der dritten Verbindungshalbleiter-Schicht (23) angeordnet und galvanisch mit dieser verbunden wird, und
   wobei die zweite elektrisch leitfähige Schicht (32) auf der der zweiten Verbindungshalbleiter-Schicht (22) gegenüberliegenden Seite der dritten Verbindungshalbleiter-Schicht (23) angeordnet wird, sodass die dritte Verbindungshalbleiter-Schicht (23) zwischen der zweiten Verbindungshalbleiter-Schicht (22) und der zweiten elektrisch leitfähigen Schicht (32) angeordnet ist.
26. Verfahren nach einem der Ausführungsbeispiele 14 bis 25,
   wobei das Substrat (10) mittels einem an seiner ersten Hauptoberfläche (11) angeordneten Kontaktierungsabschnitt (110) galvanisch und/oder mechanisch mit einer zusätzlichen separaten elektronischen Bauelementstruktur (101) verbunden wird, wobei die zusätzliche separate elektronische Bauelementstruktur (101) der ersten Hauptoberfläche (11) gegenüberliegend angeordnet ist, und/oder
   wobei das Substrat (10) mittels einem an seiner zweiten Hauptoberfläche (12) angeordneten Kontaktierungsabschnitt galvanisch und/oder mechanisch mit der zusätzlichen separaten elektronischen Bauelementstruktur (101) oder mit einer weiteren zusätzlichen separaten elektronischen Bauelementstruktur verbunden wird, wobei diese der zweiten Hauptoberfläche (12) gegenüberliegend angeordnet ist,
   um ein dreidimensionales elektronisches Halbleiter-Bauelement (1000) zu erzeugen.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Vertikale Verbindungshalbleiter-Struktur (100), aufweisend:
ein Substrat (10) mit einer ersten Hauptoberfläche (11) und einer gegenüberliegenden zweiten Hauptoberfläche (12),
eine vertikale Kanalöffnung (13), die sich zwischen der ersten Hauptoberfläche (11) und der zweiten Hauptoberfläche (12) vollständig durch das Substrat (10) hindurch erstreckt,
einen innerhalb der vertikalen Kanalöffnung (13) angeordneten Schichtstapel (20),
wobei der Schichtstapel (20) eine innerhalb der vertikalen Kanalöffnung (13) angeordnete elektrisch leitfähige Schicht (31) und eine innerhalb der vertikalen Kanalöffnung (13) angeordnete Verbindungshalbleiter-Schicht (21) aufweist,
wobei die Verbindungshalbleiter-Schicht (21) einen auf der elektrisch leitfähigen Schicht (31) angeordneten und mit der elektrisch leitfähigen Schicht (31) galvanisch verbundenen Verbindungshalbleiter aufweist.

2. Vertikale Verbindungshalbleiter-Struktur (100) nach Anspruch 1,
wobei die Verbindungshalbleiter-Schicht (21) einen monokristallinen Verbindungs-Halbleiter aufweist, und/oder
wobei die Verbindungshalbleiter-Schicht (21) mindestens eine Elementkombination aus der Gruppe der Übergangsmetalle und der Gruppe der Chalkogeniden aufweist.

3. Vertikale Verbindungshalbleiter-Struktur (100) nach einem der vorhergehenden Ansprüche,
wobei die elektrisch leitfähige Schicht (31) innerhalb der vertikalen Kanalöffnung (13) direkt und unmittelbar auf dem Substrat (10) angeordnet ist, oder
wobei innerhalb der vertikalen Kanalöffnung (13) eine Isolatorschicht (33) zwischen dem Substrat (10) und der elektrisch leitfähigen Schicht (31) angeordnet ist.

4. Vertikale Verbindungshalbleiter-Struktur (100) nach einem der vorhergehenden Ansprüche,
wobei die Verbindungshalbleiter-Schicht (21) mittels Abscheidung auf der elektrisch leitfähigen Schicht (31) angeordnet ist, oder
wobei die Verbindungshalbleiter-Schicht (21) mittels chemischer Umsetzung aus zumindest einem Teil der elektrisch leitfähigen Schicht (31) gebildet ist.

5. Vertikale Verbindungshalbleiter-Struktur (100) nach einem der vorhergehenden Ansprüche,
wobei der Schichtstapel (20) eine innerhalb der vertikalen Kanalöffnung (13) angeordnete zweite Verbindungshalbleiter-Schicht (22) aufweist, die auf der Verbindungshalbleiter-Schicht (21) angeordnet und galvanisch mit dieser verbunden ist,
wobei die zweite Verbindungshalbleiter-Schicht (22) auf der der elektrisch leitfähigen Schicht (31) gegenüberliegenden Seite der Verbindungshalbleiter-Schicht (21) angeordnet ist, sodass die Verbindungshalbleiter-Schicht (21) zwischen der elektrisch leitfähigen Schicht (31) und der zweiten Verbindungshalbleiter-Schicht (22) angeordnet ist.

6. Vertikale Verbindungshalbleiter-Struktur (100) nach Anspruch 5,
wobei der Schichtstapel (20) eine innerhalb der vertikalen Kanalöffnung (13) angeordnete dritte Verbindungshalbleiter-Schicht (23) aufweist, die auf der zweiten Verbindungshalbleiter-Schicht (22) angeordnet und galvanisch mit dieser verbunden ist,
wobei die dritte Verbindungshalbleiter-Schicht (23) auf der der Verbindungshalbleiter-Schicht (21) gegenüberliegenden Seite der zweiten Verbindungshalbleiter-Schicht (22) angeordnet ist, sodass die zweite Verbindungshalbleiter-Schicht (22) zwischen der Verbindungshalbleiter-Schicht (21) und der dritten Verbindungshalbleiter-Schicht (23) angeordnet ist.

7. Vertikale Verbindungshalbleiter-Struktur (100) nach einem der vorhergehenden Ansprüche,
wobei die Verbindungshalbleiter-Schicht (21) und/oder die zweite Verbindungshalbleiter-Schicht (22) und/oder die dritte Verbindungshalbleiter-Schicht (23) mindestens ein 2D-Verbundmaterial aufweist.

8. Vertikale Verbindungshalbleiter-Struktur (100) nach Anspruch 6 oder 7,
wobei der Schichtstapel (20) eine innerhalb der vertikalen Kanalöffnung (13) angeordnete zweite elektrisch leitfähige Schicht (32) aufweist, die auf der dritten Verbindungshalbleiter-Schicht (23) angeordnet und galvanisch mit dieser verbunden ist,
wobei die zweite elektrisch leitfähige Schicht (32) auf der der zweiten Verbindungshalbleiter-Schicht (22) gegenüberliegenden Seite der dritten Verbindungshalbleiter-Schicht (23) angeordnet ist, sodass die dritte Verbindungshalbleiter-Schicht (23) zwischen der zweiten Verbindungshalbleiter-Schicht (22) und der zweiten elektrisch leitfähigen Schicht (23) angeordnet ist.

9. Dreidimensionales elektronisches Halbleiter-Bauelement (1000) mit mindestens einer vertikalen Verbindungshalbleiter-Struktur (100) gemäß einem der vorhergehenden Ansprüche,
wobei der ersten und/oder der zweiten Hauptoberfläche (11, 12) des Substrats (10) gegenüberliegend eine zusätzliche separate elektronische Bauelementstruktur (101) angeordnet ist, die mittels einem Kontaktierungsabschnitt (110) mechanisch und/oder galvanisch mit der vertikalen Verbindungshalbleiter-Struktur (100) verbunden ist.

10. Verfahren zum Herstellen einer vertikalen Verbindungshalbleiter-Struktur (100), wobei das Verfahren die folgenden Schritte aufweist:
Bereitstellen (201) eines Substrats (10) mit einer ersten Hauptoberfläche (11) und einer gegenüberliegenden zweiten Hauptoberfläche (12),
Strukturieren (202) einer vertikalen Kanalöffnung (13), die sich zwischen der ersten Hauptoberfläche (11) und der zweiten Hauptoberfläche (12) vollständig durch das Substrat (10) hindurch erstreckt,
Erzeugen (203) eines Schichtstapels (20) innerhalb der vertikalen Kanalöffnung (13), wobei der Schritt des Erzeugens des Schichtstapels (20) beinhaltet:
Anordnen (203a) einer elektrisch leitfähigen Schicht (31) innerhalb der vertikalen Kanalöffnung (13), und
Anordnen (203b) einer Verbindungshalbleiter-Schicht (21) innerhalb der vertikalen Kanalöffnung (13),
wobei die Verbindungshalbleiter-Schicht (21) auf der elektrisch leitfähigen Schicht (31) angeordnet und mit der elektrisch leitfähigen Schicht (31) galvanisch verbunden wird.

11. Verfahren nach Anspruch 10,
wobei der Schritt (203b) des Anordnens der Verbindungshalbleiter-Schicht (21) beinhaltet, dass ein monokristalliner Verbindungs-Halbleiter auf der elektrisch leitfähigen Schicht (31) angeordnet wird, und/oder
wobei der Schritt (203b) des Anordnens der Verbindungshalbleiter-Schicht (21) beinhaltet, dass mindestens eine Elementkombination aus der Gruppe der Übergangsmetalle und aus der Gruppe der Chalkogeniden auf der elektrisch leitfähigen Schicht (31) angeordnet wird.

12. Verfahren nach einem der Ansprüche 10 oder 11,
wobei der Schritt (203b) des Anordnens der Verbindungshalbleiter-Schicht (21) beinhaltet, dass die Verbindungshalbleiter-Schicht (21) unter Anwendung eines Abscheideverfahrens auf der elektrisch leitfähigen Schicht (31) abgeschieden wird, und/oder
wobei die Verbindungshalbleiter-Schicht (21) mittels chemischer Umsetzung aus zumindest einem Teil der elektrisch leitfähigen Schicht (31) gebildet wird.

13. Verfahren nach einem der Ansprüche 10 bis 12,
wobei der Schritt (203) des Erzeugens des Schichtstapels (20) ferner beinhaltet:
Anordnen einer zweiten Verbindungshalbleiter-Schicht (22) innerhalb der vertikalen Kanalöffnung (13), wobei die zweite Verbindungshalbleiter-Schicht (22) auf der Verbindungshalbleiter-Schicht (21) angeordnet und galvanisch mit dieser verbunden wird, und
wobei die zweite Verbindungshalbleiter-Schicht (22) auf der der elektrisch leitfähigen Schicht (31) gegenüberliegenden Seite der Verbindungshalbleiter-Schicht (21) angeordnet wird, sodass die Verbindungshalbleiter-Schicht (21) zwischen der elektrisch leitfähigen Schicht (31) und der zweiten Verbindungshalbleiter-Schicht (22) angeordnet ist.

14. Verfahren nach Anspruch 13,
wobei der Schritt (203) des Erzeugens des Schichtstapels (20) ferner beinhaltet:
Anordnen einer dritten Verbindungshalbleiter-Schicht (23) innerhalb der vertikalen Kanalöffnung (13), wobei die dritte Verbindungshalbleiter-Schicht (23) auf der zweiten Verbindungshalbleiter-Schicht (22) angeordnet und galvanisch mit dieser verbunden wird, und
wobei die dritte Verbindungshalbleiter-Schicht (23) auf der der ersten Verbindungshalbleiter-Schicht (21) gegenüberliegenden Seite der zweiten Verbindungshalbleiter-Schicht (22) angeordnet wird, sodass die zweite Verbindungshalbleiter-Schicht (22) zwischen der Verbindungshalbleiter-Schicht (21) und der dritten Verbindungshalbleiter-Schicht (23) angeordnet ist.

15. Verfahren nach Anspruch 14,
wobei der Schritt (203) des Erzeugens des Schichtstapels (20) ferner beinhaltet:
Anordnen einer zweiten elektrisch leitfähigen Schicht (32) innerhalb der vertikalen Kanalöffnung (13), wobei die zweite elektrisch leitfähige Schicht (32) auf der dritten Verbindungshalbleiter-Schicht (23) angeordnet und galvanisch mit dieser verbunden wird, und
wobei die zweite elektrisch leitfähige Schicht (32) auf der der zweiten Verbindungshalbleiter-Schicht (22) gegenüberliegenden Seite der dritten Verbindungshalbleiter-Schicht (23) angeordnet wird, sodass die dritte Verbindungshalbleiter-Schicht (23) zwischen der zweiten Verbindungshalbleiter-Schicht (22) und der zweiten elektrisch leitfähigen Schicht (32) angeordnet ist.

16. Verfahren nach einem der Ansprüche 10 bis 15,
wobei das Substrat (10) mittels einem an seiner ersten Hauptoberfläche (11) angeordneten Kontaktierungsabschnitt (110) galvanisch und/oder mechanisch mit einer zusätzlichen separaten elektronischen Bauelementstruktur (101) verbunden wird, wobei die zusätzliche separate elektronische Bauelementstruktur (101) der ersten Hauptoberfläche (11) gegenüberliegend angeordnet ist, und/oder
wobei das Substrat (10) mittels einem an seiner zweiten Hauptoberfläche (12) angeordneten Kontaktierungsabschnitt galvanisch und/oder mechanisch mit der zusätzlichen separaten elektronischen Bauelementstruktur (101) oder mit einer weiteren zusätzlichen separaten elektronischen Bauelementstruktur verbunden wird, wobei diese der zweiten Hauptoberfläche (12) gegenüberliegend angeordnet ist,
um ein dreidimensionales elektronisches Halbleiter-Bauelement (1000) zu erzeugen.
